# EUROPEAN PATENT APPLICATION

(11) **EP 4 598 299 A1**
(43) Date of publication of application: **06.08.2025**
(21) Application number: 24218274.9
(22) Date of filing: 09.12.2024
(51) Int. Cl.: H10D 30/67, H10D 84/01, H10D 30/62

(54) **SEMICONDUCTOR DEVICE WITH BACKSIDE SOURCE/DRAIN CONTACT AND AIR STRUCTURE**

(30) Priority: 01.02.2024 KR 20240016049; 26.03.2024 KR 20240040963
(71) Applicant: Samsung Electronics Co., Ltd., Suwon-si, Gyeonggi-do 16677 (KR)
(72) Inventor: KIM, Ki-Il, 16677 Suwon-si, Gyeonggi-do (KR); SUNG, Sug Hyun, 16677 Suwon-si, Gyeonggi-do (KR); UM, Myung Yoon, 16677 Suwon-si, Gyeonggi-do (KR); YOU, Jung Gun, 16677 Suwon-si, Gyeonggi-do (KR)
(74) Representative: Kuhnen & Wacker Patent- und Rechtsanwaltsbüro PartG mbB

(57) **Abstract**

There is provided a semiconductor device including a backside source/drain contact formed at a backside thereof to be connected to a bottom surface of a first source/drain pattern, wherein a first portion of the backside contact has a tapering shape from a backside wiring line, a second portion of the backside contact has a constant width along a vertical direction, and a sacrificial epitaxial pattern is formed in an active pattern and connected to a bottom surface of a second source/drain pattern of which a top surface is connected to a frontside source/drain contact.

## Description

### CROSS-REFERENCE TO RELATED APPLICATION

This application claims priority from Korean Patent Application No. 10-2024-0040963 filed on March 26, 2024 and Korean Patent Application No. 10-2024-0016049 filed on February 1, 2024 in the Korean Intellectual Property Office, and the disclosures of which are incorporated herein in their entireties.

### BACKGROUND

### 1. Field

The present disclosure relates to a semiconductor device.

### 2. Description of the Related Art

As one of the scaling technologies to increase the density of semiconductor devices, multi-gate transistors have been proposed. The multi-gate transistors are obtained by forming multi-channel active patterns (or silicon bodies) in the shape of fins or nanowires on a substrate and then forming gates on the surfaces of the multi-channel active patterns.

The multi-gate transistors are easier to scale due to their utilization of three-dimensional (3D) channels. Additionally, the multi-gate transistors can improve current control capabilities without increasing their gate length. Moreover, the multi-gate transistors can effectively suppress the short channel effect (SCE), where the potential in a channel area is affected by the drain voltage.

Meanwhile, as the pitch size of semiconductor devices decreases, research is needed to reduce parasitic capacitance and ensure electrical stability between contacts within a semiconductor device.

### SUMMARY

Various Aspects of the present disclosure provide a semiconductor device and a method of manufacturing the same that can improve device performance and reliability.

According to an aspect of the present disclosure, there is provided a semiconductor device which may include: a backside wiring line having first and second surfaces that are opposite to each other in a third direction; a first fin-type pattern on the first surface of the backside wiring line and extending in a first direction; a second fin-type pattern on the first surface of the backside wiring linem extending in the first direction and spaced apart from the first fin-type pattern in a second direction; a first source/drain pattern on the first fin-type pattern; a second source/drain pattern on the second fin-type pattern; a first backside source/drain contact connecting the backside wiring line and the first source/drain pattern; and an air structure between the first and second source/drain patterns, the air structure overlapping the first backside source/drain contact in the second direction, wherein the first backside source/drain contact includes a first portion and a second portion, wherein the first portion of the first backside source/drain contact is disposed between the backside wiring line and the second portion of the first backside source/drain contact, wherein in the first portion of the first backside source/drain contact, a width, in the second direction, of the first backside source/drain contact decreases away from the first surface of the backside wiring line, wherein the second portion of the first backside source/drain contact is connected to the first source/drain pattern, wherein a height from the first surface of the backside wiring line to an uppermost part of the first portion of the first backside source/drain contact is smaller than a height from a level of the first surface of the backside wiring line to a lowermost part of the air structure. According to another aspect of the present disclosure, there is provided a semiconductor device which may include: a backside wiring line having first and second surfaces that are opposite to each other in a third direction; a first fin-type pattern on the first surface of the backside wiring line and extending in a first direction; a second fin-type pattern on the first surface of the backside wiring line, extending in the first direction and spaced apart from the first fin-type pattern in a second direction; a third first fin-type on the first surface of the backside wiring line and pattern extending in the first direction; a fourth fin-type pattern on the first surface of the backside wiring line, extending in the first direction and spaced apart from the third fin-type pattern in the second direction; a first source/drain pattern on the first fin-type pattern; a second source/drain pattern on the second fin-type pattern; a third source/drain pattern on the third fin-type pattern; a fourth source/drain pattern on the fourth fin-type pattern; a backside source/drain contact connecting the backside wiring line and the first source/drain pattern; a first air structure between the first and second source/drain patterns; and a second air structure between the third and fourth source/drain patterns, wherein a height, in the third direction, of the first air structure differs from a height, in the third direction, of the second air structure.

According to still another aspect of the present disclosure, there is provided a semiconductor device which may include: a first backside wiring line having first and second surfaces that are opposite to each other in a third direction; a second backside wiring line having first and second surfaces that are opposite to each other in the third direction; a first fin-type pattern on the first surface of the first backside wiring line and extending in a first direction; a plurality of first sheet patterns on the first fin-type pattern; a second fin-type pattern on the first surface of the second backside wiring line extending in the first direction and spaced apart from the first fin-type pattern in a second direction; a plurality of second sheet patterns on the second fin-type pattern; a first source/drain pattern on the first fin-type pattern and connected to the plurality of first sheet patterns; a second source/drain pattern on the second fin-type pattern and connected to the plurality of second sheet patterns; a first backside source/drain contact connecting the first backside wiring line and the first source/drain pattern; a second backside source/drain contact connecting the second backside wiring line and the second source/drain pattern; and an air structure between the first and second source/drain patterns, the air structure overlapping the first and second backside source/drain contacts in the third direction.

It should be noted that the effects are not limited to those described above, and other effects will be apparent from the following description.

### BRIEF DESCRIPTION OF DRAWINGS

The above and other aspects and features of the present disclosure will become more apparent by describing in detail example embodiments thereof with reference to the attached drawings, in which:
FIG. 1 is a layout diagram for explaining a semiconductor device according to one or more embodiments.
FIG. 2 is a cross-sectional view along line A-A in FIG. 1.
FIG. 3 is a cross-sectional view along line B-B in FIG. 1.
FIG. 4 is a cross-sectional view along line C-C in FIG. 1.
FIG. 5 is an enlarged cross-sectional view of part P in FIG. 4.
FIGS. 6 and 7 are cross-sectional views for explaining semiconductor devices according to one or more embodiments.
FIGS. 8 through 11 are cross-sectional views for explaining semiconductor devices according to one or more embodiments.
FIG. 12 is a cross-sectional view for explaining a semiconductor device according to one or more embodiments.
FIGS. 13 and 14 are cross-sectional views for explaining a semiconductor device according to one or more embodiments.
FIG. 15 is a cross-sectional view for explaining a semiconductor device according to one or more embodiments.
FIGS. 16 and 17 are diagrams for explaining a semiconductor device according to one or more embodiments.
FIGS. 18 through 21 are diagrams for explaining semiconductor devices according to various embodiments.
FIGS. 22 through 29 are cross-sectional views for explaining intermediate steps of a method of manufacturing a semiconductor device according to one or more embodiments.

### DETAILED DESCRIPTION

The embodiments described herein are non-limiting example embodiments, and thus, the disclosure is not limited thereto and may be realized in various other forms. Each of the embodiments provided herein is not excluded from being associated with one or more features of another example or another embodiment also provided herein or not provided herein but consistent with the disclosure.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

It will be understood that, although the terms "first", "second", "third", and so on may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described under could be termed a second element, component, region, layer or section, without departing from the spirit and scope of the present disclosure.

In the accompanying drawings related to semiconductor devices according to one or more embodiments, various types of transistors are given as examples, including Fin Field-Effect Transistors (FinFETs) with fin-shaped patterned channel areas, transistors containing nanowires or nanosheets, and Multi-Bridge Channel Field Effect Transistors (MBCFETs^{™}), but the present disclosure is not limited thereto.

Semiconductor devices according to one or more embodiments may include tunneling Field-Effect Transistors (FETs), three-dimensional (3D) transistors, or vertical FETs, and may also include planar transistors. Additionally, the technical concept can be applied to transistors based on two-dimensional (2D) materials and structures thereof.

Furthermore, semiconductor devices according to one or more embodiments may also include bipolar junction transistors and Lateral Diffused Metal Oxide Semiconductor (LDMOS) transistors.

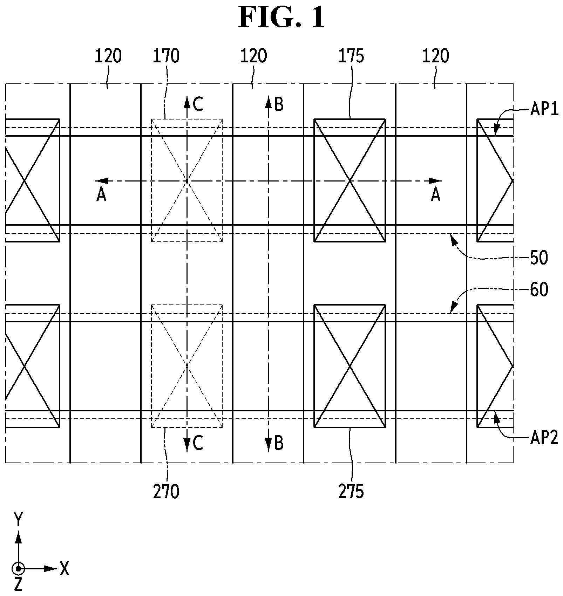

A semiconductor device according to one or more embodiments will hereinafter be described with reference to FIGS. 1 through 5.

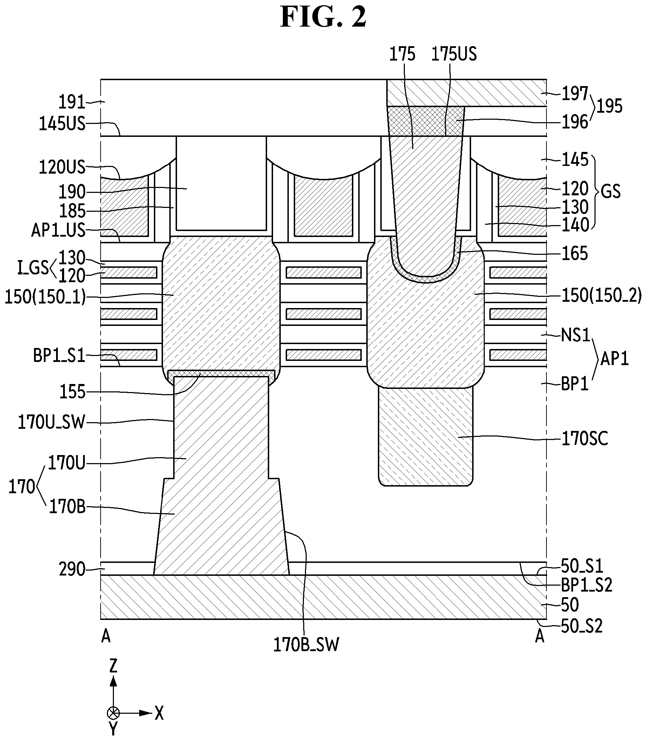

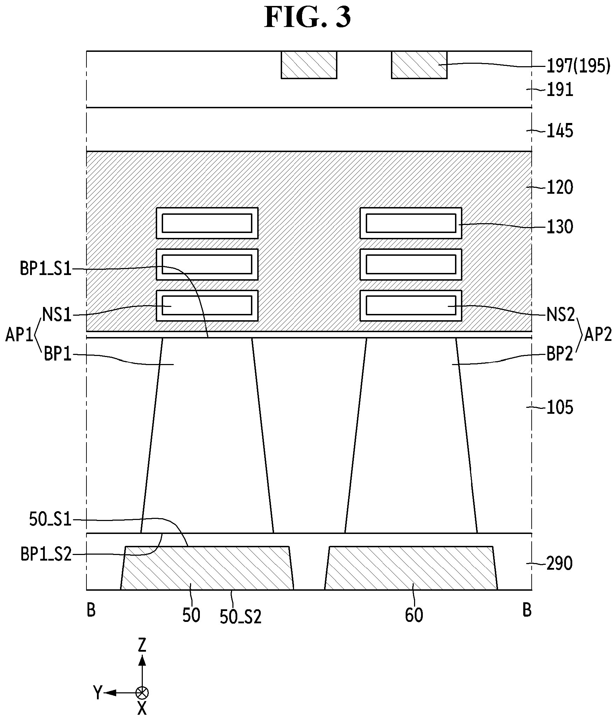

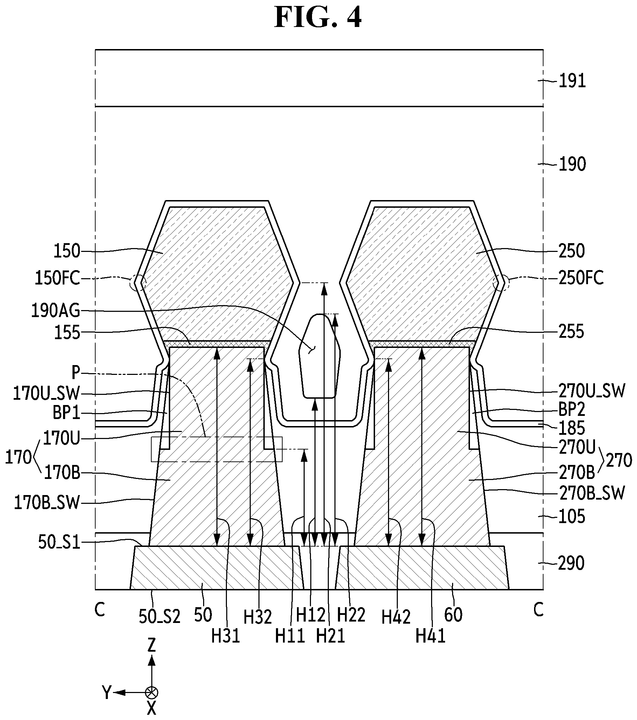

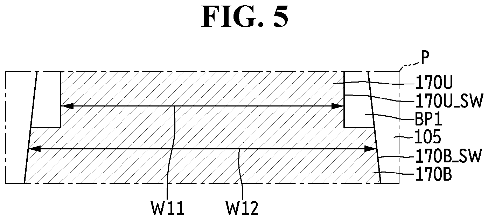

FIG. 1 is a layout diagram for explaining a semiconductor device according to one or more embodiments. FIG. 2 is a cross-sectional view along line A-A in FIG. 1. FIG. 3 is a cross-sectional view along line B-B in FIG. 1. FIG. 4 is a cross-sectional view along line C-C in FIG. 1. FIG. 5 is an enlarged cross-sectional view of part P in FIG. 4. For convenience, a frontside wiring structure 195 is not illustrated in FIG. 1.

Referring to FIGS. 1 through 5, the semiconductor device according to one or more embodiments may include a first active pattern AP1, the second active pattern AP2, a plurality of first gate electrodes 120, first source/drain patterns 150, second source/drain patterns 250, a first backside source/drain contact 170, a second backside source/drain contact 270, first frontside source/drain contacts 175, second frontside source/drain contacts 275, a first backside wiring line 50, a second backside wiring line 60, a first frontside interlayer insulating film 190, a first air structure 190AG, and the frontside wiring structure 195.

A cross-sectional view taken across the second active pattern AP2 in a first direction X may be similar to what is illustrated in FIG. 2.

The first and second backside wiring lines 50 and 60 may be disposed in a backside interlayer insulating film 290. The first and second backside wiring lines 50 and 60 may extend in the first direction X. The first backside wiring line 50 may be spaced apart from the second backside wiring line 60 in a second direction Y.

For example, the first and second backside wiring lines 50 and 60 may serve as power lines supplying power to the semiconductor device according to one or more embodiments. In another example, the first and second backside wiring lines 50 and 60 may function as signal lines delivering operational signals to the semiconductor device according to one or more embodiments. In yet another example, one of the first and second backside wiring lines 50 and 60 may be a power line, and the other backside wiring line may be a signal line.

The first backside wiring line 50 may have a first surface 50_S1 and a second surface 50_S2 that are opposite to each other in a third direction Z. The second backside wiring line 60 may have first and second surfaces that are opposite to each other in the third direction Z. The first surface 50_S1 of the first backside wiring line 50 and the first surface of the second backside wiring line 60 may be at a same level or plane, and face the first active pattern AP1 and the second active pattern AP2, respectively. Here, the first direction X may intersect the second and third directions Y and Z. Moreover, the second direction Y may intersect the third direction Z.

The first and second backside wiring lines 50 and 60 are illustrated as having a trapezoidal cross-sectional shape, but the present disclosure is not limited thereto. Alternatively, the first and second backside wiring lines 50 and 60 may have a rectangular cross-sectional shape. For example, a width, in the second direction Y, of the first surface 50_S1 of the first backside wiring line 50 may be smaller than a width, in the second direction Y, of the second surface 50_S2 of the first backside wiring line 50.

For example, the first and second backside wiring lines 50 and 60 may be formed by a damascene process. The first backside wiring line 50 may be formed by forming a trench that extends in the first direction X, in the first backside interlayer insulating film 290 and filling the trench with a conductive material.

The first and second backside wiring lines 50 and 60 are illustrated as having a single conductive film structure, but the present disclosure is not limited thereto. Alternatively, contrary to what is illustrated, the first and second backside wiring lines 50 and 60 may include a wiring barrier film and a wiring fill film. In this case, the wiring fill film may fill a trench or recess defined by the wiring barrier film.

The first and second backside wiring lines 50 and 60 may include, for example, at least one of a metal, a conductive metal nitride, a conductive metal carbide, a conductive metal oxide, a conductive metal carbonitride, and a 2D material. The 2D material may include a 2D allotrope or compound. Examples of the two-dimensional (2D) material include at least one of graphene, boron nitride (BN), molybdenum sulfide, molybdenum selenide, tungsten sulfide, tungsten selenide, and tantalum sulfide, but the present disclosure is not limited thereto. That is, the 2D material is not particularly limited.

Contrary to what is illustrated, the first and second backside wiring lines 50 and 60 may extend in the second direction Y. In this case, the cross-sectional shapes, along lines A-A, B-B, and C-C in FIG. 1, of the first and second backside wiring lines 50 and 60 may change.

The backside interlayer insulating film 290 may include, for example, at least one of silicon oxide, silicon nitride, silicon carbonitride, silicon oxynitride, and a low-k material. The dielectric constant of the low-k material may be lower than 3.9, which is the dielectric constant of silicon oxide (SiO₂). The backside interlayer insulating film 290 is illustrated as being a single layer, but the present disclosure is not limited thereto.

The first and second active patterns AP1 and AP2 may be disposed on the backside interlayer insulating film 290. Parts of the backside interlayer insulating film 290 may be disposed between the first active pattern AP1 and the first backside wiring line 50, and between the second active pattern AP2 and the second backside wiring line 60.

The first and second active patterns AP1 and AP2 may extend longitudinally in the first direction X. For example, the first and second active patterns AP1 and AP2 may be disposed on the first and second backside wiring lines 50 and 60, respectively. The first and second active patterns AP1 and AP2 may be disposed on the first surface 50_S1 of the first backside wiring line and the first surface of the second backside wiring line 60, respectively.

The first and second active patterns AP1 and AP2 may be spaced apart from each other in the second direction Y. The first and second active patterns AP1 and AP2 may be adjacent to each other in the second direction Y. For example, the first active pattern AP1 may be the nearest active pattern to the second active pattern AP2 in the second direction Y.

For example, the first and second active patterns AP1 and AP2 may both be areas where p-type transistors are formed. In another example, the first and second active patterns AP1 and AP2 may both be areas where n-type transistors are formed. In yet another example, the first active pattern AP1 may be an area where p-type transistors are formed, and the second active pattern AP2 may be an area where n-type transistors are formed.

The first and second active patterns AP1 and AP2 may be multi-channel active patterns. For example, the first active pattern AP1 may include a first base pattern BP1 and a plurality of first sheet patterns NS1. The second active pattern AP2 may include a second base pattern BP2 and a plurality of second sheet patterns NS2. In the semiconductor device according to one or more embodiments, the first and second active patterns AP1 and AP2 may be active patterns including nanosheets or nanowires.

The first and second base patterns BP1 and BP2 may be disposed on the backside interlayer insulating film 290. Part of the backside interlayer insulating film 290 may be disposed between the first base pattern BP1 and the first backside wiring line 50, and between the second base pattern BP2 and the second backside wiring line 60.

The first and second base patterns BP1 and BP2 may protrude in the third direction Z. The first and second base patterns BP1 and BP2 may be fin-type patterns.

The first and second base patterns BP1 and BP2 may extend longitudinally in the first direction X. The first and second base patterns BP1 and BP2 may be spaced apart from each other in the second direction Y. The first and second base patterns BP1 and BP2 may be separated by a fin trench extending in the first direction X.

The first base pattern BP1 may include first and second surfaces BP1_S1 and BP1_S2 that are opposite to each other in the third direction Z. The second surface BP1_S2 of the first base pattern BP1 may face the backside interlayer insulating film 290, the first backside wiring line 50, and the second backside wiring line 60. The first and second backside wiring lines 50 and 60 may be disposed on the second surface BP1_S2 of the first base pattern BP1. For example, the first base pattern BP1 may be in contact with the backside interlayer insulating film 290.

For example, the second surface BP1_S2 of the first base pattern BP1 may be a lower surface of the first base pattern BP1. The first surface BP1_S1 of the first base pattern BP1_S1 may be an upper surface of the first base pattern BP 1.

The second base pattern BP2, like the first base pattern BP1, may include first and second surfaces that are opposite to each other in the third direction Z. The second surface of the second base pattern BP2 may face the backside interlayer insulating film 290, the first backside wiring line 50, and the second backside wiring line 60. For example, the second base pattern BP2 may be in contact with the backside interlayer insulating film 290.

The first base pattern BP1 may include sidewalls that connect the first and second surfaces BP1_S1 and BP1_S2 of the first base pattern BP1. The sidewalls of the first base pattern BP1 may extend in the first direction X. The second base pattern BP2 may include sidewalls that extend in the first direction X. The sidewalls of the second base pattern BP2 may face the sidewalls of the first base pattern BP1.

The first sheet patterns NS1 may be disposed on the first base pattern BP1. The first sheet patterns NS1 may be disposed on the first surface BP1_S1 of the first base pattern BP1. The first sheet patterns NS1 may be spaced apart from the first base pattern BP1 in the third direction Z.

The second sheet patterns NS2 may be disposed on the second base pattern BP2. The second sheet patterns NS2 may be disposed on the first surface of the second base pattern BP2. The second sheet patterns NS2 may be spaced apart from the second base pattern BP2 in the third direction Z.

The first sheet patterns NS1 and the second sheet patterns NS2 may be disposed on the first surface 50_S1 of the first backside wiring line 50 and the first surface of the second backside wiring line 60. Three first sheet patterns NS1 and three second sheet patterns NS2 are illustrated as being respectively disposed along the third direction Z, but the present disclosure is not limited thereto.

Each of the first sheet patterns NS1 may include upper and lower surfaces that are opposite to each other in the third direction Z. The lower surfaces of the first sheet patterns NS1 may face the first backside wiring line 50.

The first sheet patterns NS1 may include an uppermost first sheet pattern NS1 that is farthest away from the first and second backside wiring lines 50 and 60. An upper surface AP1_US of the first active pattern AP 1 may correspond to the upper surface of the uppermost first sheet pattern NS1. The descriptions for the second active pattern AP2 and the second sheet patterns NS2 may be substantially the same as those for the first active pattern AP1 and the first sheet patterns NS1, and thus duplicate descriptions thereof may be omitted herein.

The first and second base patterns BP1 and BP2 may each include an elemental semiconductor material such as silicon (Si) or germanium (Ge). Alternatively, the first and second base patterns BP1 and BP2 may each include a compound semiconductor, for example, a group IV-IV compound semiconductor or a group III-V compound semiconductor.

The group IV-IV compound semiconductor may include, for example, a binary, ternary, or quaternary compound comprising at least two elements selected from among carbon (C), Si, Ge, and tin (Sn), or a compound obtained by doping this binary, ternary, or quaternary compound with a group IV element.

The group III-V compound semiconductor may include, for example, a binary, ternary, or quaternary compound formed by combining at least one of aluminum (Al), gallium (Ga), and indium (In), which are group III elements, with one of phosphorus (P), arsenic (As), and antimony (Sb), which are group V elements.

The first sheet patterns NS1 and the second sheet patterns NS2 may include either Si or Ge, which is an elemental semiconductor material, or a group IV-IV or III-V compound semiconductor. A width, in the second direction Y, of the first sheet patterns NS 1 may increase or decrease proportionally to a width, in the second direction Y, of the first base pattern BP1. A width, in the second direction Y, of the second sheet patterns NS2 may increase or decrease proportionally to a width, in the second direction Y, of the second base pattern BP2.

For example, the first sheet patterns NS1, disposed on the first base pattern BP1, are illustrated as having the same width in the second direction Y, but the present disclosure is not limited thereto.

A field insulating film 105 may be disposed on the first and second backside wiring lines 50 and 60. For example, the field insulating film 105 may be disposed on the first surface 50_S1 of the first backside wiring line 50 and the first surface of the second backside wiring line 60.

The field insulating film 105 may be disposed on the sidewalls of the first and second base patterns BP1 and BP2. For example, the field insulating film 105 may cover entire sidewalls of the first base pattern BP1 and the entire sidewalls of the second base pattern BP2. Alternatively, in another example, the field insulating film 105 may be disposed on only portions of the sidewalls of the first base pattern BP1 and/or portions of the sidewalls of the second base pattern BP2.

The field insulating film 105 may not be formed one or more the first surface BP1_S1 of the first base pattern BP1 and the first surface BP2_S1 of the second base pattern BP2. Based on the first and second backside wiring lines 50 and 60, the first sheet patterns NS1 and the second sheet patterns NS2 are positioned higher than the upper surface of the field insulating film 105. The field insulating film 105 may have upper and lower surfaces that are opposite to each other in the third direction Z. The lower surface of the field insulating film 105 may face the first and second backside wiring lines 50 and 60.

The field insulating film 105 may include, for example, an oxide layer, a nitride layer, an oxynitride layer, or a combination thereof. The field insulating film 105 is illustrated as being a single layer, but the present disclosure is not limited thereto.

A plurality of gate structures GS may be disposed on the upper surface of the field insulating film 105. The gate structures GS may extend in the second direction Y. The gate structures GS may be spaced apart from one another in the first direction X. The gate structures GS may be adjacent to one another in the first direction X.

The gate structures GS may be disposed on the first and second active patterns AP1 and AP2. The gate structures GS may intersect the first and second active patterns AP1 and AP2.

The gate structures GS may be disposed on the first and second base patterns BP1 and BP2. The gate structures GS may surround each of the first sheet patterns NS1. The gate structures GS may surround each of the second sheet patterns NS2.

The gate structures GS are illustrated as being disposed across the first and second active patterns AP1 and AP2, but the present disclosure is not limited thereto. That is, some of the gate structures GS may be divided into two sections by a gate separation structure disposed on the field insulating film 105, and may thereby be disposed over the first and second active patterns AP1 and AP2.

The gate structures GS may include, for example, first gate electrodes 120, a first gate insulating film 130, first gate spacers 140, and first gate capping patterns 145.

The gate structures GS may include a plurality of inner gate structures I_GS, which are disposed between each pair of adjacent first sheet patterns NS1 in the third direction Z, and between the first base pattern BP1 and the first sheet patterns NS1. The inner gate structures I_GS may be disposed between the first surface BP1_S1 of the first base pattern BP1 and the lower surfaces of the first sheet pattern NS1, and between the opposing upper and lower surfaces of each pair of adj acent first sheet pattern NS1 in the third direction Z. The inner gate structures I_GS may include the first gate electrodes 120 and the first gate insulating film 130.

The number of inner gate structures I_GS may be equal to the number of first sheet patterns NS1. The inner gate structures I_GS contact the first surface BP1_S1 of the first base pattern BP1 and the upper surfaces and lower surfaces of the first sheet patterns NS1. In the semiconductor device according to one or more embodiments, the inner gate structures I_GS may contact the first source/drain patterns 150 that will be described later.

The inner gate structures I_GS include the first gate electrodes 120 and the first gate insulating film 130 that are disposed between each pair of adjacent first sheet patterns NS1, and between the first base pattern BP1 and the first sheet patterns NS1.

The inner gate structures I_GS may be disposed between each pair of adjacent second sheet patterns NS2 in the third direction Z, and between the second base pattern BP2 and the second sheet patterns NS2.

The first gate electrodes 120 may be disposed on the first and second base patterns BP1 and BP2. The first gate electrodes 120 may intersect the first and second base patterns BP1 and BP2. The first gate electrodes 120 may surround the first sheet patterns NS1 and the second sheet patterns NS2.

In a cross-sectional view such as FIG. 2, upper surfaces 120US of the first gate electrodes 120 are illustrated as being concave surfaces, but the present disclosure is not limited thereto. Alternatively, the upper surfaces 120US of the first gate electrodes 120 may be flat.

The first gate electrodes 120 may include at least one of a metal, a metal alloy, a conductive metal nitride, a metal silicide, a doped semiconductor material, a conductive metal oxide, and a conductive metal oxynitride. The first gate electrodes 120 may include, for example, titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), Al, copper (Cu), cobalt (Co), titanium (Ti), tantalum (Ta), nickel (Ni), platinum (Pt), nickel platinum (NiPt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), and a combination thereof, but the present disclosure is not limited thereto. Here, the conductive metal oxide and conductive metal oxynitride may include oxidized forms of the aforementioned materials, but the present disclosure is not limited thereto.

The first gate insulating film 130 may extend along the upper surface of the field insulating film 105, the upper surface BP1_US of the first base pattern BP1, and the upper surface of the second base pattern BP2. The first gate insulating film 130 may surround the first sheet patterns NS1. The first gate insulating film 130 may surround the second sheet patterns NS2. The first gate insulating film 130 may be disposed along the circumferences of the first sheet patterns NS1 and the circumferences of the second sheet patterns NS2. The first gate electrodes 120 may be disposed on the first gate insulating film 130.

The first gate insulating film 130 may be disposed between the first gate electrodes 120 and the first sheet patterns NS1, and between the first gate electrodes 120 and the second sheet patterns NS2. In one or more embodiments, the first gate insulating film 130 included in the first inner gate structures I_GS1 may contact the first source/drain patterns 150, which will be described later.

The first gate insulating film 130 may include silicon oxide, silicon oxynitride, silicon nitride, or a high-k dielectric material that has a higher dielectric constant than silicon oxide. The high-k dielectric material may include, for example, at least one of boron nitride, hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate.

The first gate insulating film 130 is illustrated as being a single film, but the present disclosure is not limited thereto. The first gate insulating film 130 may include multiple films. The first gate insulating film 130 may include an interfacial film and a high-k insulating film disposed between the first active pattern AP1 and the first gate electrode 120, and between the second active patterns AP2 and the first gate electrode 120. For example, the interfacial films may not be formed along the profile of the upper surface of the field insulating film 105.

The semiconductor device according to one or more embodiments may include a negative capacitance (NC) field-effect transistor (FET) utilizing a negative capacitor. For example, the first gate insulating film 130 may include a ferroelectric material film with ferroelectric properties and a paraelectric material film with paraelectric properties.

The ferroelectric material film may have an NC, and the paraelectric material film may have positive capacitance. For example, if two or more capacitors are connected in series, and each of the capacitors has a positive capacitance, the total capacitance of the capacitors is reduced compared to the capacitance of each of the capacitors. Conversely, if at least one of the capacitors has an NC, the total capacitance of the capacitors may have a positive value and may be greater than the absolute value of the capacitance of each of the capacitors.

When a ferroelectric material film with an NC and a paraelectric material film with a positive capacitance are connected in series, the total capacitance of the ferroelectric and paraelectric material films may increase. Utilizing this capacitance increase, the transistor including the ferroelectric material film can have a subthreshold swing (SS) of 60 mV/decade or less at room temperature.

The ferroelectric material film may have ferroelectric properties. For example, the ferroelectric material film may include at least one of hafnium oxide, hafnium zirconium oxide, barium strontium titanium oxide, barium titanium oxide, and lead zirconium titanium oxide. Here, the hafnium zirconium oxide may be, for example, a material obtained by doping hafnium oxide with zirconium (Zr). Alternatively, the hafnium zirconium oxide may be the compound of hafnium (Hf), Zr, and oxygen (O).

The ferroelectric material film may further include a dopant. For example, the dopant may include at least one of Al, Ti, Nb, lanthanum (La), yttrium (Y), magnesium (Mg), Si, calcium (Ca), cerium (Ce), dysprosium (Dy), erbium (Er), gadolinium (Gd), Ge, scandium (Sc), strontium (Sr), and Sn. The type of the dopant included in the ferroelectric material film may vary depending on the type of the ferroelectric material included in the ferroelectric material film.

When the ferroelectric material film includes hafnium oxide, a dopant included in the ferroelectric material film may include at least one of Gd, Si, Zr, Al, and Y.

If the dopant is Al, the ferroelectric material film may contain 3 to 8 atomic % (at%) of Al. Here, the proportion of the dopant may be the ratio of Al to the sum of Hf and Al.

If the dopant is Si, the ferroelectric material film may contain 2 to 10 at% of Si. If the dopant is Y, the ferroelectric material film may contain 2 to 10 at% of Y. If the dopant is Gd, the ferroelectric material film may contain 1 to 7 at% of Gd. If the dopant is Zr, the ferroelectric material film may contain 50 to 80 at% of Zr.

The paraelectric material film may have paraelectric properties. For example, the paraelectric material film may include at least one of silicon oxide and a high-k metal oxide. The high-k metal oxide may include at least one of hafnium oxide, zirconium oxide, and aluminum oxide, but the present disclosure is not limited thereto.

The ferroelectric material film and the paraelectric material film may include a same material. The ferroelectric material film may have ferroelectric properties, but the paraelectric material film may not have ferroelectric properties. For example, if both the ferroelectric and paraelectric material films include hafnium oxide, the crystal structure of the hafnium oxide in the ferroelectric material film may differ from the crystal structure of the hafnium oxide in the paraelectric material film.

The ferroelectric material film may have a thickness that exhibits ferroelectric properties. For example, the thickness of the ferroelectric material film may be 0.5 to 10 nm, but the present disclosure is not limited thereto. Since the critical thickness for exhibiting ferroelectric properties may vary from one ferroelectric material to another, the thickness of the ferroelectric material film may vary depending on its material.

For example, the first gate insulating film 130 may include one ferroelectric material film. Alternatively, the first gate insulating film 130 may include a plurality of ferroelectric material films that are spaced apart from one another. Each of the first gate insulating film 130 may have a layered film structure in which a plurality of ferroelectric material films and a plurality of paraelectric material films are alternately stacked.

The first gate spacers 140 may be disposed on sidewalls of the gate structures GS. The first gate spacers 140 may not be disposed between the first base pattern BP1 and the first sheet patterns NS1, and between each pair of adj acent first sheet patterns NS1 in the third direction Z.

The first gate spacers 140 may include, for example, at least one of silicon nitride (SiN), silicon oxynitride (SiON), silicon dioxide (SiO₂), silicon oxycarbonitride (SiOCN), silicon boron nitride (SiBN), silicon oxyboron nitride (SiOBN), silicon oxycarbide (SiOC), and a combination thereof. The first gate spacers 140 are illustrated as being single films, but the present disclosure is not limited thereto.

The first gate capping patterns 145 may be disposed on the first gate electrodes 120. Upper surfaces 145US of the first gate capping patterns 145 may be on a same plane as an upper surface of the first frontside interlayer insulating film 190.

Alternatively, contrary to what is illustrated, the first gate capping patterns 145 may be disposed between the first gate spacers 140. Yet alternatively, the gate structures GS may not include the first gate capping patterns 145. The gate capping patterns 145 may not be disposed on the first gate electrodes 120.

The first gate capping patterns 145 may include, for example, at least one of SiN, SiON, silicon carbonitride (SiCN), SiOCN, and a combination thereof. The first gate capping patterns 145 may include a material that has an etch selectivity relative to a first frontside interlayer insulating film 190.

The first source/drain patterns 150 may be disposed on the first active pattern AP1. For example, the first source/drain patterns 150 may be disposed on the first base pattern BP1.

The first source/drain patterns 150 may be disposed between each pair of adjacent first gate electrodes 120 in the first direction X. The first source/drain patterns 150 may be disposed on sides of the first gate electrodes 120. The first source/drain patterns 150 may contact the first active pattern AP1. For example, the first source/drain patterns 150 may contact the first sheet patterns NS1. The first source/drain patterns 150 may be disposed on the first surface 50_S1 of the first backside wiring line 50 and on the first surface of the second back wiring line 60.

The first source/drain patterns 150 may include a first backside connective epitaxial pattern 150_1 and a first frontside connective epitaxial pattern 150_2. The first backside connective epitaxial pattern 150_1 may be connected to the first backside wiring line 50. The first frontside connective epitaxial pattern 150_2 may be connected to a frontside wiring line 197.

The second source/drain patterns 250 may be disposed on the second active pattern AP2. For example, the second source/drain patterns 250 may be disposed on the second base pattern BP2.

The second source/drain patterns 250 may contact the second active pattern AP2. For example, the second source/drain patterns 250 may contact the second sheet patterns NS2. The second source/drain patterns 250 may be disposed on the first surface 50_S1 of the first back wiring line 50 and on the first surface of the second backside wiring line 60.

Similarly to the first source/drain patterns 150, the second source/drain patterns 250 may include second backside connective epitaxial patterns and second frontside connective epitaxial patterns that may be connected to the second backside wiring line 60 and the frontside wiring line 197, respectively.

The first source/drain patterns 150 may be included in a source/drain of a transistor that uses the first sheet patterns NS1 as a channel area. The second source/drain patterns 250 may be included in a source/drain of a transistor that uses the second sheet patterns NS2 as a channel area.

In FIG. 4, the first source/drain patterns 150 and the second source/drain patterns 250 are illustrated as having a hexagon-like shape, but the present disclosure is not limited thereto. Alternatively, the first source/drain patterns 150 and the second source/drain patterns 250 may have a different polygon shape such as a pentagon-like shape, not being limited thereto.

The first source/drain patterns 150 may include sidewalls that extend in the third direction Z. For example, from a cross-sectional perspective, the sidewalls of the first source/drain patterns 150 may include upper sloped sidewalls and lower sloped sidewalls. The lower sloped sidewalls of the first source/drain patterns 150 may be closer than the upper sloped sidewalls of the first source/drain patterns 150 to the first backside wiring line 50.

The first source/drain patterns 150 may include first facet intersections 150FC where the upper sloped sidewalls and the lower sloped sidewalls meet. At the first facet intersections 150FC, a width, in the second direction Y, of the first source/drain patterns 150 may reach its maximum.

Similarly to the first source/drain patterns 150, the second source/drain patterns 250 may include second facet intersections 250FC. At the second facet intersections 250FC, a width, in the second direction Y, of the second source/drain patterns 250 may reach its maximum.

The first source/drain patterns 150 and the second source/drain patterns 250 may each include epitaxial patterns. The first source/drain patterns 150 and the second source/drain patterns 250 may each include a semiconductor material.

The first source/drain patterns 150 and the second source/drain patterns 250 may include, for example, an elemental semiconductor material such as Si or Ge. Additionally, the first source/drain patterns 150 and the second source/drain patterns 250 may include, for example, a binary or ternary compound comprising at least two elements selected from among C, Si, Ge, and Sn, or a compound obtained by doping this binary or ternary compound with a group IV element. The first source/drain patterns 150 and the second source/drain patterns 250 may each include an epitaxial film formed of a semiconductor material. The first source/drain patterns 150 and the second source/drain patterns 250 are illustrated as being single films, but the present disclosure is not limited thereto.

The first source/drain patterns 150 and the second source/drain patterns 250 may include a dopant doped into a semiconductor material. For example, the first source/drain patterns 150 and the second source/drain patterns 250 may include a p-type dopant. In another example, the first source/drain patterns 150 and the second source/drain patterns 250 may include an n-type dopant. In yet another example, the first source/drain patterns 150 may include a p-type dopant, while the second source/drain patterns 250 may include an n-type dopant.

The p-type dopant may include at least one of boron (B) and gallium (Ga), but the present disclosure is not limited thereto. The n-type dopant may include at least one of phosphorus (P), arsenic (As), antimony (Sb), and bismuth (Bi), but the present disclosure is not limited thereto.

A first sacrificial epitaxial pattern 170SC may be disposed in the first base pattern BP1. The first sacrificial epitaxial pattern 170SC may be disposed between one of the first source/drain patterns 150 and the first backside wiring line 50. The one of the first source/drain patterns 150 may be disposed above the first sacrificial epitaxial pattern 170SC. The first sacrificial epitaxial pattern 170SC may overlap the one of the first source/drain patterns 150 in the third direction Z.

For example, the first sacrificial epitaxial pattern 170SC may be disposed between the first frontside connective epitaxial pattern 150_2 and the first backside wiring line 50. The first frontside connective epitaxial pattern 150_2 may be disposed on the first sacrificial epitaxial pattern 170SC. The first frontside connective epitaxial pattern 150_2 may overlap the first sacrificial epitaxial pattern 170SC in the third direction Z.

The first sacrificial epitaxial pattern 170SC may also be disposed in the second base pattern BP2. The first sacrificial epitaxial pattern 170SC may be disposed below the second source/drain pattern 250 connected to the frontside wiring line 197. The first sacrificial epitaxial pattern 170SC may be disposed between the second source/drain patterns 250 and the second backside wiring line 60.

The first sacrificial epitaxial pattern 170SC may include a material that has an etch selectivity relative to the first and second base patterns BP1 and BP2. The first sacrificial epitaxial pattern 170SC may include a semiconductor material.

The first frontside interlayer insulating film 190 is disposed on the first and second base patterns BP1 and BP2 and the field insulating film 105. The first frontside interlayer insulating film 190 may be disposed on the first source/drain patterns 150 and the second source/drain patterns 250. The first frontside interlayer insulating film 190 may not be formed on the upper surfaces of the first gate capping patterns 145. For example, the upper surface of the first frontside interlayer insulating film 190 may be on the same plane as the upper surfaces 145US of the first gate capping patterns 145.

The first frontside interlayer insulating film 190 is disposed on the first surface 50_S1 of the first backside wiring line 50 and the first surface of the second backside wiring line 60.

The first frontside interlayer insulating film 190 may include, for example, at least one of silicon oxide, silicon nitride, silicon oxynitride, and a low-k material. The low-k material may include, for example, Fluorinated TetraEthylOrthoSilicate (FTEOS), Hydrogen Silsesquioxane (HSQ), bis-benzocyclobutene (BCB), TetraMethylOrthoSilicate (TMOS), OctaMethylCycloTetraSiloxane (OMCTS), HexaMethylDiSiloxane (HMDS), TriMethylSilyl Borate (TMSB), DiAcetoxyDitertiaryButoSiloxane (DADBS), TriMethylSilyl Phosphate (TMSP), PolyTetraFluoroEthylene (PTFE), Tonen SilaZen (TOSZ), Fluoride Silicate Glass (FSG), polypropylene oxide-like polyimide nanofoam, Carbon Doped silicon Oxide (CDO), Organo Silicate Glass (OSG), SiLK, Amorphous Fluorinated Carbon, silica aerogel, silica xerogel, mesoporous silica, and a combination thereof, but the present disclosure is not limited thereto.

A source/drain etch stop film 185 may extend along profiles of the first source/drain patterns 150 and the profiles of the second source/drain patterns 250. The source/drain etch stop film 185 may be disposed between each of the first source/drain patterns 150 and the first frontside interlayer insulating film 190, and between each of the second source/drain patterns 250 and the first frontside interlayer insulating film 190.

The source/drain etch stop film 185 may include, for example, at least one of SiN, SiON, SiOCN, SiBN, SiOBN, SiOC, and a combination thereof.

The first backside source/drain contact 170 may extend in the third direction Z. The first backside source/drain contact 170 may be connected to one of the first source/drain patterns 150. For example, the first backside source/drain contact 170 may be connected to the first backside connective epitaxial pattern 150_1. The first backside source/drain contact 170 is electrically connected to the first backside connective epitaxial pattern 150_1. For example, the first backside source/drain contact 170 may be formed on a bottom surface of the first backside connective epitaxial pattern 150_1.

The first backside source/drain contact 170 may be disposed between the first backside connective epitaxial pattern 150_1 and the first backside wiring line 50. The first backside source/drain contact 170 connects the first backside connective epitaxial pattern 150_1 and the first backside wiring line 50.

The first backside source/drain contact 170 may be connected to the first backside wiring line 50. The first backside source/drain contact 170 may be connected to the first surface 50_S1 of the first backside wiring line 50.

The first backside source/drain contact 170 may be disposed in the backside interlayer insulating film 290 and the first base pattern BP1. Part of the first backside source/drain contact 170 may be disposed in the backside interlayer insulating film 290. The first backside source/drain contact 170 may extend from the first surface 50_S1 of the first backside wiring line 50 to the first backside connective epitaxial pattern 150.

The second backside source/drain contact 270 may extend in the third direction Z. The second backside source/drain contact 270 may be connected to one of the second source/drain patterns 250. For example, the second backside source/drain contact 270 may be connected to the second backside connective epitaxial pattern. The second backside source/drain contact 270 is electrically connected to the second backside connective epitaxial pattern. For example, the second backside source/drain contact 270 may be formed on a bottom surface of the second backside connective epitaxial pattern.

The second backside source/drain contact 270 may be disposed between the second backside connective epitaxial pattern and the second backside wiring line 60. The second backside source/drain contact 270 connects the second backside connective epitaxial pattern and the second backside wiring line 60.

The second backside source/drain contact 270 may be disposed in the backside interlayer insulating film 290 and the second base pattern BP2. Part of the second backside source/drain contact 270 may be disposed in the backside interlayer insulating film 290.

Contrary to what is illustrated, a single backside wiring line may be disposed below the first and second active patterns AP1 and AP2. In this case, the first backside source/drain contact 170 and the second backside source/drain contact 270 may be connected to the same backside wiring line.

The first backside source/drain contact 170 may include a first portion 170B and a second portion 170U. The first portion 170B of the first backside source/drain contact 170 is directly connected to the second portion 170U of the first backside source/drain contact 170.

The first portion 170B of the first backside source/drain contact 170 may be disposed between the second portion 170U of the first backside source/drain contact 170 and the first backside wiring line 50.

The first portion 170B of the first backside source/drain contact 170 may be connected to the first backside wiring line 50. The first portion 170B of the first backside source/drain contact 170 may be part of the first backside source/drain contact 170 that is connected to the first backside wiring line 50. In the first portion 170B of the first backside source/drain contact 170, a width W12, in the second direction Y, of the first backside source/drain contact 170 may decrease away from the first surface 50_S1 of the first backside wiring line 50.

The second portion 170U of the first backside source/drain contact 170 may be connected to the first backside connective epitaxial pattern 150_1. The second portion 170U of the first backside source/drain contact 170 may be parts of the first backside source/drain contact 170 that is connected to the first backside connective epitaxial pattern 150. In the second portion 170U of the first backside source/drain contact 170, a width W11, in the second direction Y, of the first backside source/drain contact 170 is illustrated as being uniform, but the present disclosure is not limited thereto.

For example, at points where the width, in the second direction Y, of the first backside source/drain contact 170 changes, the second portion 170U of the first backside source/drain contact 170 may be distinguished from the first portion 170B of the first backside source/drain contact 170. For example, near a boundary between the second portion 170U and the first portion 170B of the first backside source/drain contact 170, the width, in the second direction Y, of the first backside source/drain contact 170 may decrease abruptly.

In another example, at points where a slope of sidewalls (170B_SW and 170U_SW) of the first backside source/drain contact 170 changes, the second portion 170U of the first backside source/drain contact 170 may be distinguished from the first portion 170B of the first backside source/drain contact 170. Near the boundary between the second portion 170U and the first portion 170B of the first backside source/drain contact 170, the slope of sidewalls 170B_SW of the first portion 170B may differ from the slope of sidewalls 170U_SW of the second portion 170U.

Through the tendency for the width of the first backside source/drain contact 170 to change, or changes in the slope of the sidewalls (170B_SW and 170U_SW) of the first backside source/drain contact 170, the second portion 170U of the first backside source/drain contact 170 may be distinguished from the first portion 170B of the first backside source/drain contact 170.

The second backside source/drain contact 270 may include a first portion 270B and a second portion 270U. The first portion 270B of the second backside source/drain contact 270 is directly connected to the second portion 270U of the second backside source/drain contact 270.

The first portion 270B of the second backside source/drain contact 270 may be disposed between the second portion 270U of the second backside source/drain contact 270 and the second backside wiring line 60. The descriptions for the first and second portions 270B and 270U of the second backside source/drain contact 270 may be substantially the same as those for the first and second portions 170B and 170U of the first backside source/drain contact 170.

Through the tendency for the width of the second backside source/drain contact 270 to change, or changes in a slope of sidewalls (270B_SW and 270U_SW) of the second backside source/drain contact 270, the second portion 270U of the second backside source/drain contact 270 may be distinguished from the first portion 270B of the second backside source/drain contact 270.

A height H31 from the first surface 50_S1 of the first backside wiring line 50 to an uppermost part of the first backside source/drain contact 170 may be the same as a height H41 from the level of the first surface 50_S1 of the first backside wiring line 50 to an uppermost part of the second backside source/drain contact 270.

A height H32 from the first surface 50_S1 of the first backside wiring line 50 to lowermost parts of the first source/drain patterns 150 may be the same as a height H42 from the level of the first surface 50_S1 of the first backside wiring line 50 to lowermost parts of the second source/drain patterns 250. Here, in the combined structure of the first source/drain patterns 150 and a first backside contact silicide film 155, the lowermost parts of the first source/drain patterns 150 may be closest to the first backside wiring line 50 in the third direction Z. The lowermost parts of the second source/drain patterns 250 may be defined in the same manner as the lowermost parts of the first source/drain patterns 150.

The height (H31 - H32) by which the first backside source/drain contact 170 is recessed into the first source/drain patterns 150 may be the height from the lowermost parts of the first source/drain patterns 150 to the uppermost part of the first backside source/drain contact 170. For example, the height (H31 - H32) by which the first backside source/drain contact 170 is recessed into the first source/drain patterns 150 may be the same as the height (H41 - H42) by which the second backside source/drain contact 270 is recessed into the second source/drain patterns 250.

The first and second backside source/drain contacts 170 and 270 are illustrated as having a single conductive film structure, but the present disclosure is not limited thereto. Alternatively, contrary to what is illustrated, the first and second backside source/drain contacts 170 and 270 may each have a multilayer conductive film structure that includes a contact barrier film and a contact fill film.

The first and second backside source/drain contacts 170 and 270 may include, for example, at least one of a metal, a conductive metal nitride, a conductive metal carbide, a conductive metal oxide, a conductive metal carbonitride, and a 2D material.

Contrary to what is illustrated, the first backside source/drain contact 170 and the first backside wiring line 50 may have an integral structure with no particular boundary therebetween. The second backside source/drain contact 270 and the second backside wiring line 60 may also have an integral structure with no particular boundary therebetween.

A contact insulation liner may be disposed along at least parts of the sidewalls (170B_SW and 170U_SW) of the first backside source/drain contact 170. The contact insulation liner may also be disposed along at least parts of the sidewalls (270B_SW and 270U_SW) of the second backside source/drain contact 270. The contact insulation liner may include an insulating material.

The first backside contact silicide film 155 may be disposed between the first backside source/drain contact 170 and the first source/drain patterns 150. The first backside contact silicide film 155 contacts the first backside source/drain contact 170. A second backside contact silicide film 255 may be disposed between the second backside source/drain contact 270 and the second source/drain patterns 250. The second backside contact silicide film 255 contacts the second backside source/drain contact 270. The first and second backside contact silicide films 155 and 255 may include a metal silicide material.

The first air structure 190AG may be disposed in the first frontside interlayer insulating film 190. The first air structure 190AG may be surrounded by the first frontside interlayer insulating film 190. Herein, the term air structure may refer to an air gap.

The first air structure 190AG may be disposed between the first source/drain pattern 150 and the second source/drain pattern 250. The first air structure 190AG may also be disposed between the first and second backside source/drain contacts 170 and 270.

The first air structure 190AG may overlap the first and second backside source/drain contacts 170 and 270 in the second direction Y. For example, at least part of the first air structure 190AG may overlap the first and second backside source/drain contacts 170 and 270 in the second direction Y.

The first air structure 190AG may be extended in the first direction X to be disposed in the first frontside interlayer insulating film 190 between another first source/drain pattern 150 and another second source/drain pattern 250 connected to the first source/drain pattern 150 and the second source/drain pattern 250 through the first sheet patterns NS1 and the second sheet patterns NS2, respectively.

A height H21 from the first surface 50_S1 of the first backside wiring line 50 to the first facet intersections 150FC of the first source/drain patterns 150 is greater than a height H22 from a level of the first surface 50_S1 of the first backside wiring line 50 to an uppermost part of the first air structure 190AG. A height H11 from the first surface 50_S1 of the first backside wiring line 50 to uppermost parts of the first portion 170B of the first backside source/drain contact 170 is smaller than a height H12 from a level of the first surface 50_S1 of the first backside wiring line 50 to a lowermost part of the first air structure 190AG.

As the first air structure 190AG is disposed between the first and second backside source/drain contacts 170 and 270, capacitance between the first and second backside source/drain contacts 170 and 270 can be reduced. Consequently, the performance and reliability of the semiconductor device according to one or more embodiments can be improved.

The first frontside source/drain contact 175 may extend in the third direction Z. The first frontside source/drain contact 175 may be connected to one of the first source/drain patterns 150. For example, the first frontside source/drain contact 175 may be connected to the first frontside connective epitaxial pattern 150_2. The first frontside source/drain contact 175 is electrically connected to the first frontside connective epitaxial pattern 150_2.

The first frontside source/drain contact 175 is disposed on the first surface BP1_S1 of the first base pattern BP1. The first frontside source/drain contact 175 may be disposed in the first frontside interlayer insulating film 190 and in the first source/drain patterns 150. Parts of the first frontside source/drain contact 175 may be disposed in the first frontside connective epitaxial pattern 150_2. The first frontside source/drain contact 175 does not penetrate the first base pattern BP1.

A height from a level of the upper surface AP1_US of the first active pattern AP1 to an upper surface 175US of the first frontside source/drain contact 175 may be the same as a height from the upper surface AP1_US of the first active pattern AP 1 to the upper surfaces 145US of the first gate capping patterns 145, in the third direction Z.

The first frontside source/drain contacts 175 are illustrated as having a single conductive film structure, but the present disclosure is not limited thereto. Alternatively, contrary to what is illustrated, the first frontside source/drain contact 175 may each have a multilayer conductive film structure that includes a contact barrier film and a contact fill film.

The first frontside source/drain contacts 175 may include, for example, at least one of a metal, a conductive metal nitride, a conductive metal carbide, a conductive metal oxide, a conductive metal carbonitride, and a 2D material.

The shape in which the second frontside source/drain contacts 275 are electrically connected to the second source/drain patterns 250 on the second base pattern BP2 may be similar to what is illustrated in FIG. 2.

A first frontside contact silicide film 165 may be disposed between the first frontside source/drain contact 175 and the first source/drain pattern 150. The first frontside contact silicide film 165 may include a metal silicide material.

The second frontside interlayer insulating film 191 may be disposed on the first frontside interlayer insulating film 190, the gate structures GS, and the first frontside source/drain contacts 175. The second frontside interlayer insulating film 191 may be disposed on the second frontside source/drain contacts 275. The second frontside interlayer insulating film 191 may include, for example, at least one of silicon oxide, silicon nitride, silicon carbonitride, silicon oxynitride, and a low-k material.

The frontside wiring structure 195 may be disposed in the second frontside interlayer insulating film 191. The frontside wiring structure 195 is disposed on the first surface 50_S1 of the first backside wiring line 50 and the first surface of the second backside wiring line 60. The frontside wiring structure 195 may include a frontside via plug 196 and a frontside wiring line 197.

The frontside wiring structure 195 may be connected to the first frontside source/drain contacts 175. The frontside wiring structure 195 may be connected to the upper surfaces 175US of the first frontside source/drain contacts 175.

The first frontside source/drain contacts 175 may be disposed between the frontside wiring structure 195 and the first source/drain patterns 150. The first frontside source/drain contacts 175 may connect the frontside wiring structure 195 and the first source/drain patterns 150. The first frontside source/drain contacts 175 may be connected to the frontside wiring line 197. For example, the frontside wiring structure 195 may not be connected to the first source/drain pattern 150 connected to the first backside source/drain contact 170.

Contrary to what is illustrated, the frontside wiring structure 195 may be connected through a different frontside source/drain contact to the first backside connective epitaxial pattern 150_1. That is, the frontside wiring structure 195 may be connected to the first backside source/drain contact 170 via the first backside connective epitaxial pattern 150_1.

The frontside via plug 196 and the frontside wiring line 197 may each include, for example, at least one of a metal, a conductive metal nitride, a conductive metal carbide, a conductive metal oxide, a conductive metal carbonitride, and a 2D material.

The frontside via plug 196 and the frontside wiring line 197 are illustrated as having a single conductive film structure, but the present disclosure is not limited thereto. Alternatively, contrary to what is illustrated, at least one of the frontside via plug 196 and the frontside wiring line 197 may have a multilayer conductive film structure. Yet alternatively, the frontside wiring structure 195 may have an integral structure without no particular boundary between the frontside via plug 196 and the frontside wiring line 197.

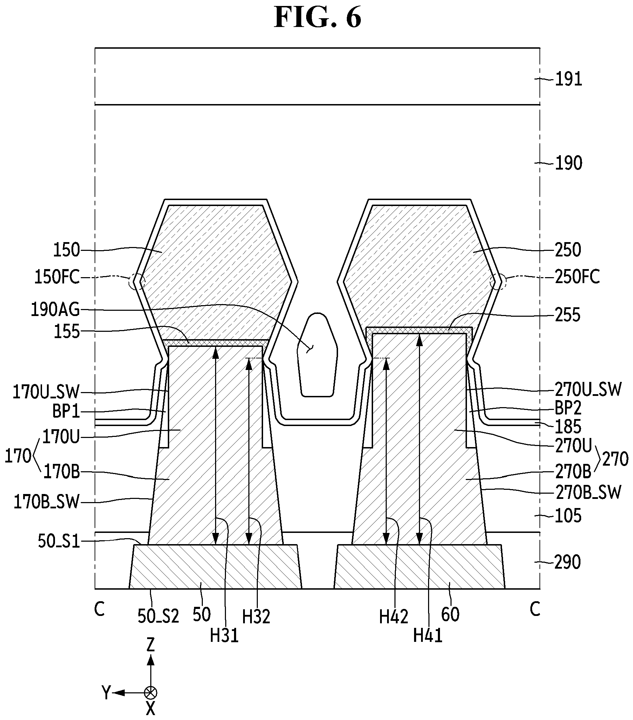

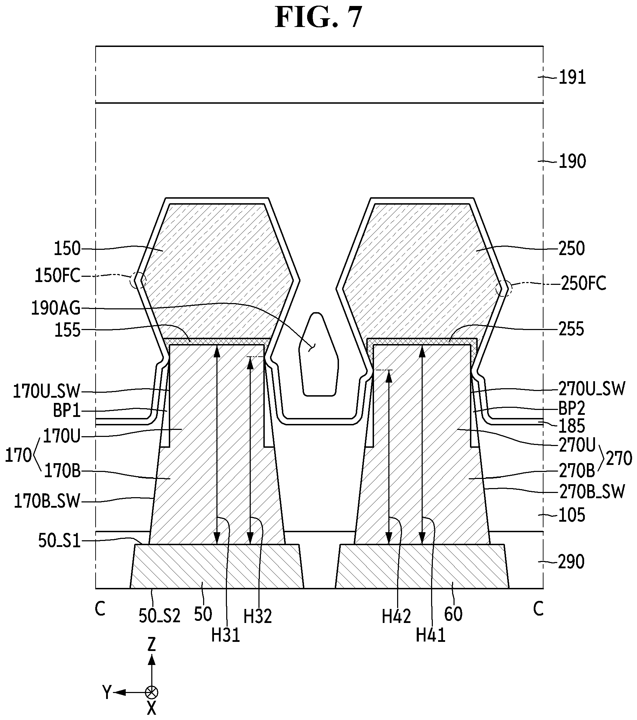

FIGS. 6 and 7 are cross-sectional views for explaining semiconductor devices according to one or more embodiments. For convenience, the embodiments of FIGS. 6 and 7 will hereinafter be described, focusing mainly on the differences from what has been described with reference to FIGS. 1 through 5.

Referring to FIGS. 6 and 7, in each of the semiconductor devices according to one or more embodiments, a height (H31 - H32) by which a first backside source/drain contact 170 is recessed into first source/drain pattern 150 may differ from a height (H41 - H42) by which a second backside source/drain contact 270 is recessed into second source/drain pattern 250.

A height of a second portion 170U of the first backside source/drain contact 170 recessed into the first source/drain pattern 150 may differ from a height of a second portion 270U of the second backside source/drain contact 270 recessed into the second source/drain patterns 250.

Referring to FIG. 6, a height H31 from a first surface 50_S1 of a first backside wiring line 50 to an uppermost part of the first backside source/drain contact 170 may be smaller than a height H41 from the level of the first surface 50_S1 of the first backside wiring line 50 to an uppermost part of the second backside source/drain contact 270. A height H32 from the first surface 50_S1 of the first backside wiring line 50 to a lowermost part of the first source/drain pattern 150 may be the same as a height H42 from the level of the first surface 50_S1 of the first backside wiring line 60 to a lowermost part of the second source/drain pattern 250.

Referring to FIG. 7, a height H32 from the first surface 50_S1 of the first backside wiring line 50 to a lowermost part of the first source/drain pattern 150 may be greater than a height H42 from the level of the first surface 50_S1 of the first backside wiring line 60 to a lowermost part of the second source/drain pattern 250. A height H31 from the first surface 50_S1 of the first backside wiring line 50 to an uppermost part of the first backside source/drain contact 170 may be the same as a height H41 from the level of the first surface 50_S1 of the first backside wiring line 60 to an uppermost part of the second backside source/drain contact 270.

Contrary to what is illustrated in FIGS. 6 and 7, based on the level of the first surface 50_S1 of the first backside wiring line 50, the height of the lowermost parts of the first source/drain patterns 150 may differ from the height of the lowermost parts of the second source/drain patterns 250. Additionally, based on the level of the first surface 50_S1 of the first backside wiring line 50, the height of the uppermost part of the first backside source/drain contact 170 may differ from the height of the uppermost part of the second backside source/drain contact 270.

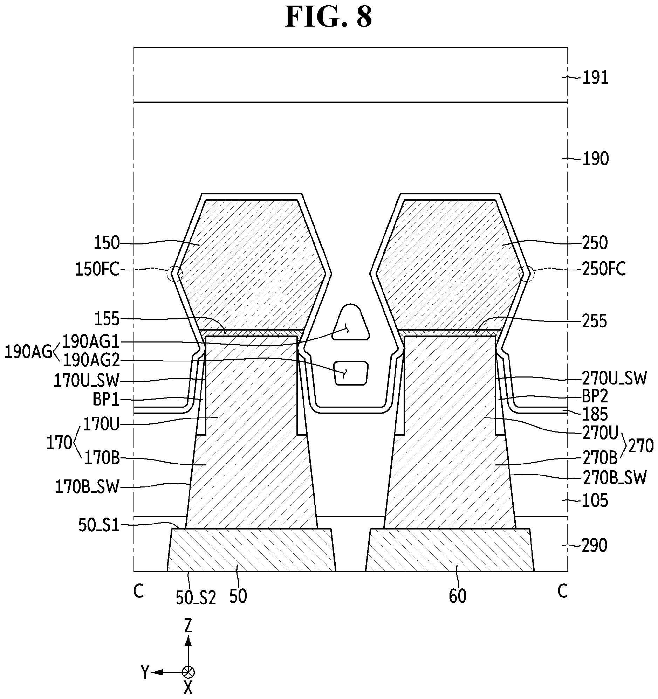

FIGS. 8 through 11 are cross-sectional views for explaining semiconductor devices according to one or more embodiments. For convenience, the embodiments of FIGS. 8 through 11 will hereinafter be described, focusing mainly on the differences from what has been described with reference to FIGS. 1 through 5.

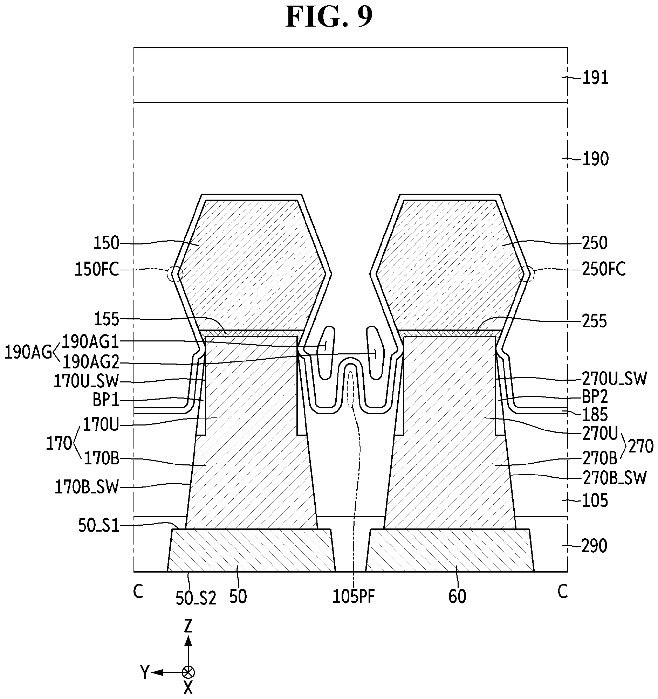

Referring to FIGS. 8 and 9, in each of the semiconductor devices according to one or more embodiments, a first air structure 190AG may include a first sub-air structure 190AG1 and a second sub-air structure 190AG2.

The first and second sub-air structures 190AG1 and 190AG2 may be disposed in a first frontside interlayer insulating film 190. The first and second sub-air structures 190AG1 and 190AG2 may be surrounded by the first frontside interlayer insulating film 190.

Referring to FIG. 8, the first and second sub-air structures 190AG1 and 190AG2 may be spaced apart from each other in the third direction Z.

Referring to FIG. 9, the first and second sub-air structures 190AG1 and 190AG2 may be spaced apart from each other in the second direction Y. A field insulating film 105 may include a field protrusion area 105PF, which protrudes in the third direction Z between the first source/drain pattern 150 and the second source/drain pattern 250. The field protrusion area 105PF may be disposed between the first and second sub-air structures 190AG1 and 190AG2.

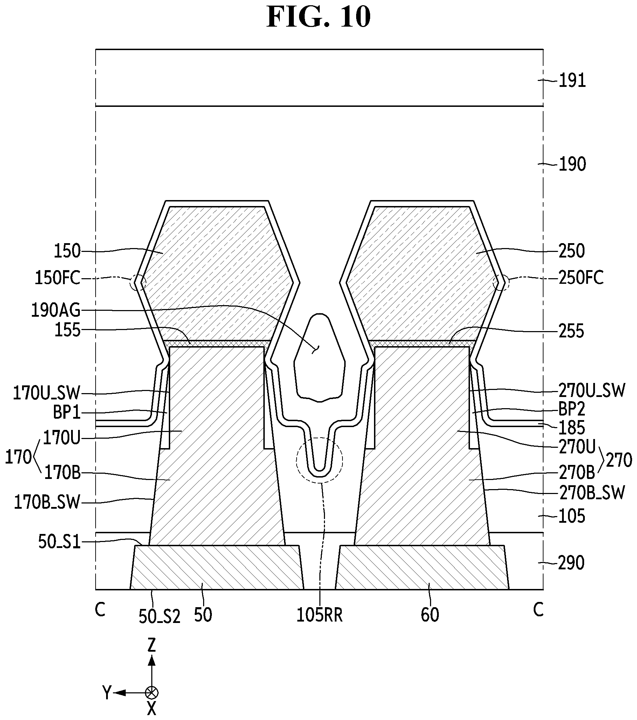

Referring to FIG. 10, in the semiconductor device according to one or more embodiments, the field insulating film 105 may include a field recess region 105RR, which is recessed toward the level of the first backside wiring line 50 and the second backside wiring line 60.

In the field recess region 105RR, a thickness, in the third direction Z, of the field insulating film 105 may decrease sharply and then increase sharply in the second direction Y.

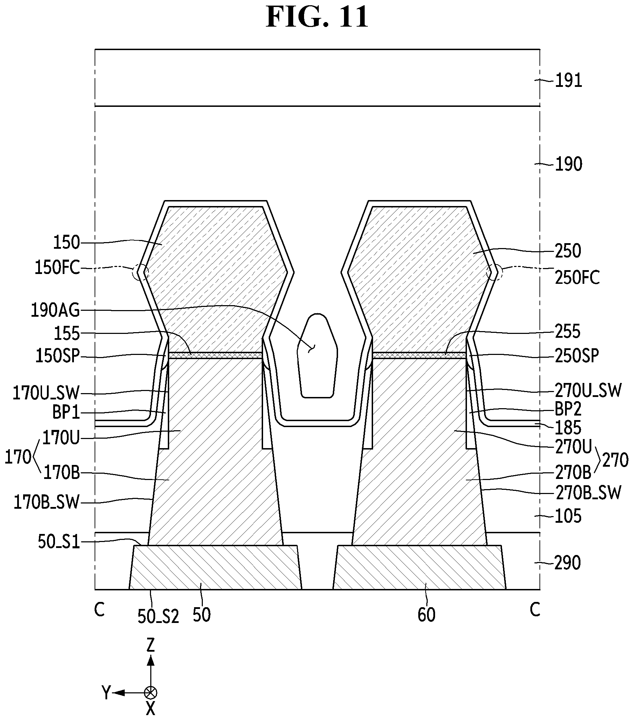

Referring to FIG. 11, the semiconductor device according to one or more embodiments may further include first epitaxial spacers 150SP and second epitaxial spacers 250SP.

The first epitaxial spacers 150SP and the second epitaxial spacers 250SP may be disposed on the field insulating film 105.

The first epitaxial spacers 150SP may be disposed on the sidewalls of the first source/drain patterns 150. The first epitaxial spacers 150SP may contact the first source/drain patterns 150. The first epitaxial spacers 150SP may be disposed between the first source/drain pattern 150 and the source/drain etch stop film 185.

The second epitaxial spacers 250SP may be disposed on the sidewalls of the second source/drain patterns 250. The second epitaxial spacers 250SP may contact the second source/drain patterns 250. The second epitaxial spacers 250SP may be disposed between the second source/drain pattern 250 and the source/drain etch stop film 185.

The first epitaxial spacers 150SP and the second epitaxial spacers 250SP may include, for example, at least one of SiN, SiON, SiO₂, SiOCN, SiBN, SiOBN, SiOC, and a combination thereof.

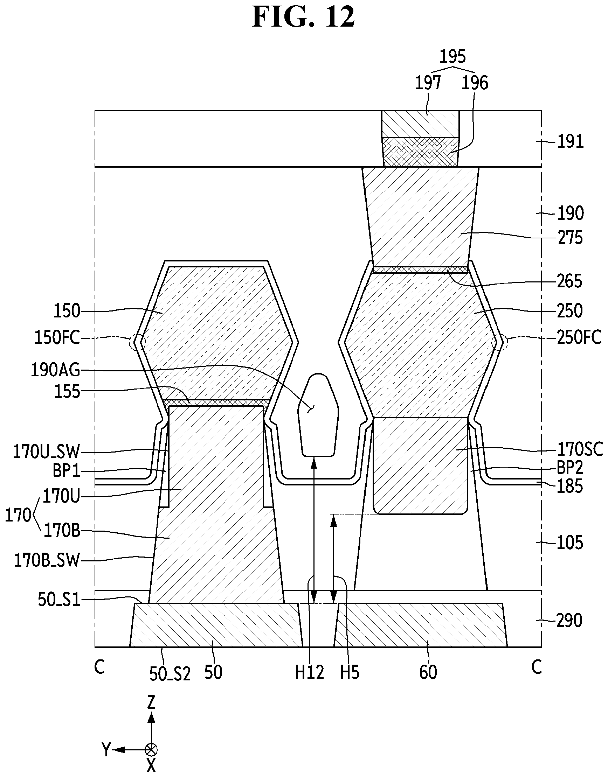

FIG. 12 is a cross-sectional view for explaining a semiconductor device according to one or more embodiments. For convenience, the embodiment of FIG. 12 will hereinafter be described, focusing mainly on the differences from what has been described with reference to FIGS. 1 through 5.

Referring to FIG. 12, in the semiconductor device according to one or more embodiments, a first air structure 190AG may be disposed between a first backside source/drain contact 170 and a first sacrificial epitaxial pattern 170SC.

The first sacrificial epitaxial pattern 170SC may be disposed between a second source/drain pattern 250 and a second backside wiring line 60. The first air structure 190AG may overlap the first sacrificial epitaxial pattern 170SC, which is disposed in a second base pattern BP2, in the second direction Y.

A height H5 from a level of a first surface 50_S1 of a first backside wiring line 50 to a lowermost part of the first sacrificial epitaxial pattern 170SC may be smaller than a height H12 from the level of the first surface 50_S1 of the first backside wiring line 50 to a lowermost part of the first air structure 190AG.

Second frontside source/drain contacts 275 may extend in the third direction Z. The second frontside source/drain contacts 275 may be connected to the second source/drain patterns 250 that are disposed on the first sacrificial epitaxial pattern 170SC, respectively.

The second frontside source/drain contacts 275 are electrically connected to the second source/drain patterns 250 that are disposed on the first sacrificial epitaxial pattern 170SC. For example, the second frontside source/drain contacts 275 may be connected to top surfaces of the second source/drain patterns 250, respectively. The second frontside source/drain contacts 275 may be connected to a frontside wiring line 197.

A second frontside contact silicide film 265 may be disposed between the second frontside source/drain contact 275 and the second source/drain pattern 250. The second frontside contact silicide film 265 may include a metal silicide material.

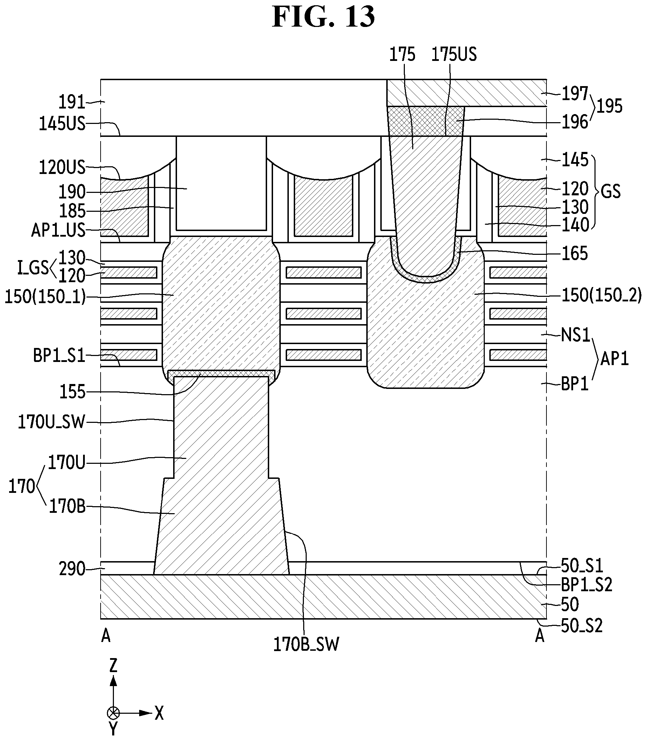

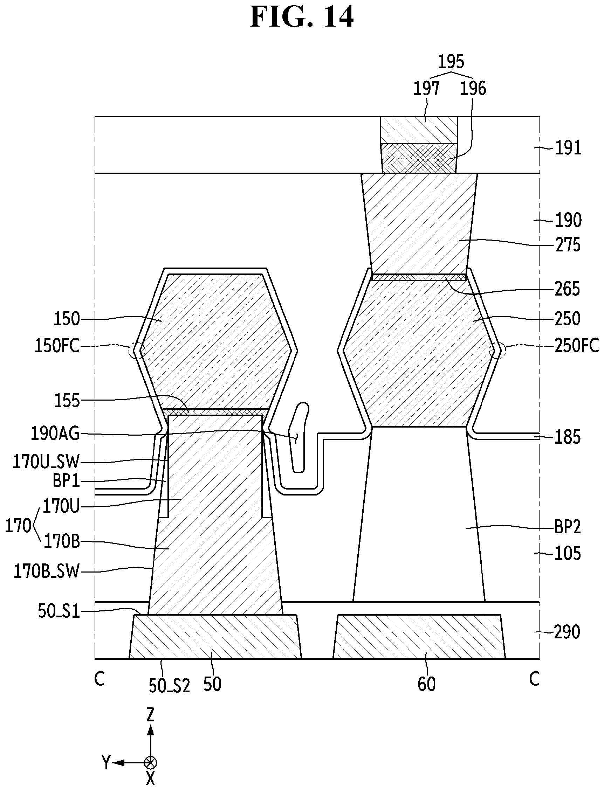

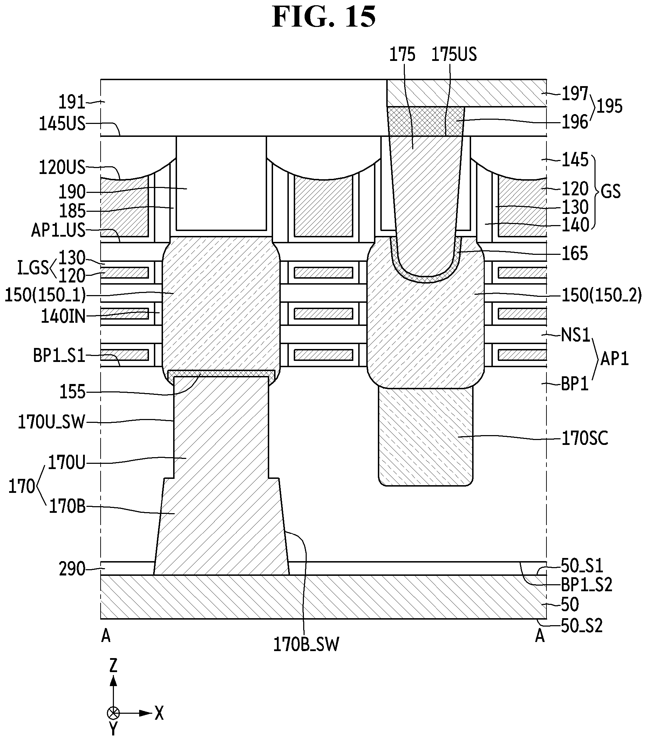

FIGS. 13 and 14 are cross-sectional views for explaining a semiconductor device according to one or more embodiments. FIG. 15 is a cross-sectional view for explaining a semiconductor device according to one or more embodiments. For convenience, the embodiments of FIGS. 13 through 15 will hereinafter be described, focusing mainly on the differences from what has been described with reference to FIGS. 1 through 5.

Referring to FIGS. 13 and 14, in the semiconductor device according to one or more embodiments, the first sacrificial epitaxial pattern 170SC of FIG. 2 may not be disposed below a first frontside source/drain contact 175 connected to a first source/drain pattern 150.

Similarly, the first sacrificial epitaxial pattern 170SC of FIG. 12 may not be disposed below a second frontside source/drain contact 275 connected to a second source/drain pattern 250.

The first sacrificial epitaxial pattern 170SC (of FIG. 2 or 12) may be formed below the first source/drain pattern 150 connected to the first backside source/drain contact 170, or below the second source/drain pattern 250 connected to the second backside source/drain contact 270 of FIG. 4. The first sacrificial epitaxial pattern 170SC may be removed during formation of the first and second backside source/drain contacts 170 and 270.

Referring to FIG. 14, a first air structure 190AG may be biased toward the first backside source/drain contact 170. During the formation of the first sacrificial epitaxial pattern 170SC, a field insulating film 105 may be more etched around the first source/drain patterns 150 than around the second source/drain patterns 250. That is, the field insulating film 105 may have a stepped shape protruding toward the second source/drain patterns 250, between the first source/drain patterns 150 and the second source/drain patterns 250.

Referring to FIG. 15, the semiconductor device according to one or more embodiments may further include inner spacers 140IN, which are disposed between inner gate structures I_GS and first source/drain patterns 150.

The inner spacers 140IN may be disposed between each pair of adjacent first sheet patterns NS1 in the third direction Z, and between the first sheet patterns NS1 and a first base pattern BP1. The inner spacers 140IN may contact the first source/drain patterns 150.

The inner spacers 140IN may include an insulating material.

For example, in a cross-sectional view taken across a second active pattern AP2 in the first direction X, the inner spacers 140IN may be disposed between the inner gate structures I_GS and second source/drain patterns 250.

Alternatively, in the cross-sectional view taken across the second active pattern AP2 in the first direction X, the inner spacers 140IN may not be disposed between the inner gate structures I_GS and the second source/drain patterns 250. That is, the cross-sectional view taken across the second active pattern AP2 in the first direction X may be similar to what is illustrated in FIG. 2.

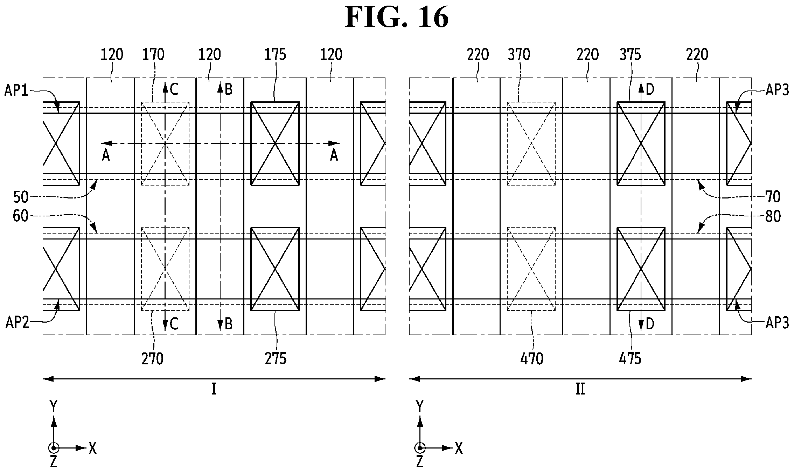

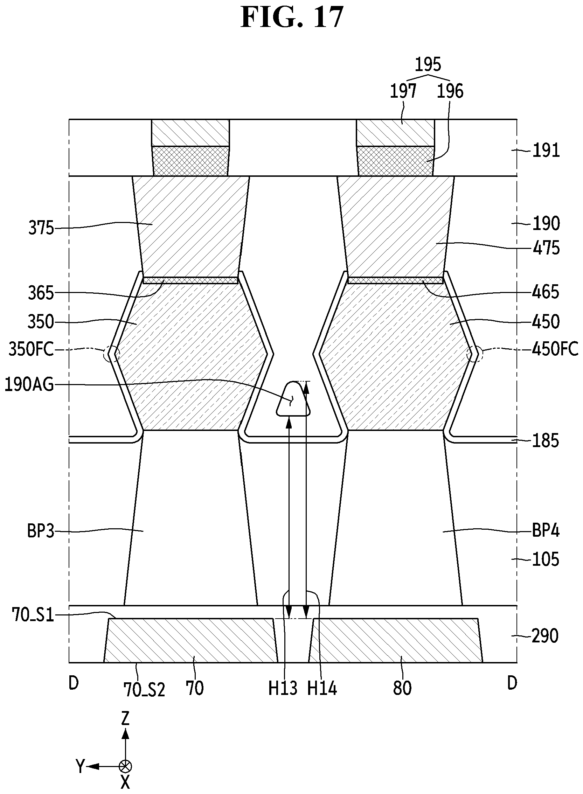

FIGS. 16 and 17 are diagrams for explaining a semiconductor device according to one or more embodiments. Specifically, FIG. 16 is a layout view for explaining a semiconductor device according to one or more embodiments. FIG. 17 is a cross-sectional view taken along line D-D in FIG. 16.

Meanwhile, the descriptions for area I in FIG. 16 may be substantially the same as those given in FIGS. 1 through 15. The embodiment of FIGS. 16 and 17 will hereinafter be described, focusing mainly on area II in FIG. 16.

A cross-sectional view taken across third and fourth backside source/drain contacts 370 and 470 along the second direction Y may be similar to what is illustrated in FIG. 4. A cross-sectional view taken across third and fourth active patterns AP3 and AP4 along the first direction X may be similar to what is illustrated in FIG. 13. A cross-sectional view taken across second gate electrodes 220 along the second direction Y may be similar to what is illustrated in FIG. 3.

Referring to FIGS. 16 and 17, the semiconductor device according to one or more embodiments may include first, second, third, and fourth active patterns AP1, AP2, AP3, and AP4, a plurality of first gate electrodes 120, a plurality of second gate electrodes 220, first source/drain patterns 150, second source/drain patterns 250, third source/drain patterns 350, fourth source/drain patterns 450, first source/drain contacts 170, second source/drain contacts 270, a third source/drain contact 370, a fourth backside source/drain contact 470, first frontside source/drain contacts 175, second frontside source/drain contacts 275, third frontside source/drain contacts 375, fourth frontside source/drain contacts 475, first, second, third, and fourth backside wiring lines 50, 60, 70, and 80, first and second air structures 190AG and 191AG, and a frontside wiring structure 195.

A substrate 100 may include areas I and II. Areas I and II may be adjacent to each other or may be spaced apart from each other.

The first active pattern AP1, the second active pattern AP2, the first gate electrodes 120, the first source/drain patterns 150, the second source/drain patterns 250, the first backside source/drain contact 170, the second backside source/drain contact 270, the first frontside source/drain contacts 175, the second frontside source/drain contacts 275, the first backside wiring line 50, the second backside wiring line 60, and the first air structure 190AG may be disposed in area I of the substrate 100.

The third active pattern AP3, the fourth active pattern AP4, the second gate electrodes 220, the third source/drain patterns 350, the fourth source/drain patterns 450, the third backside source/drain contact 370, the fourth backside source/drain contact 470, the third frontside source/drain contacts 375, the fourth frontside source/drain contacts 475, the third backside wiring line 70, the fourth backside wiring line 80, and the second air structure 191AG may be disposed in area II of the substrate 100.

The frontside wiring structure 195 may be disposed across areas I and II of the substrate 100.

For example, the third active pattern AP3 may be the same pattern as the first active pattern AP1, and the fourth active pattern AP4 may be the same pattern as the second active pattern AP2. That is, the first and third active patterns AP1 and AP3 may be different parts of the same active pattern. In this case, the first and third backside wiring lines 50 and 70 may be different parts of the same backside wiring line.

Alternatively, the third active pattern AP3 may be the same pattern as the first active pattern AP1, but the fourth active pattern AP4 may be a different pattern from the second active pattern AP2. Yet alternatively, the third active pattern AP3 may be a different pattern from the first and second active patterns AP1 and AP2, and the fourth active pattern AP4 may be a different pattern from the first and second active patterns AP1 and AP2.

The descriptions for the third and fourth active patterns AP3 and AP4 may be substantially the same as those for the first and second active patterns AP1 and AP2. The description for the second gate electrodes 220 may be substantially the same as that for the first gate electrodes 120. The descriptions for the third source/drain patterns 350 and the fourth source/drain patterns 450 may be substantially the same as those for the first source/drain patterns 150 and the second source/drain patterns 250. The descriptions for the third backside source/drain contact 370 and the fourth backside source/drain contact 470 may be substantially the same as those for the first backside source/drain contact 170 and the second backside source/drain contact 270. The descriptions for the third frontside source/drain contacts 375 and the fourth frontside source/drain contacts 475 may be substantially the same as those for the first frontside source/drain contacts 175 and the second frontside source/drain contacts 275. The descriptions for the third and fourth backside wiring lines 70 and 80 may be substantially the same as those for the first and second backside wiring lines 50 and 60.

Subsequent explanations will briefly describe each component of the semiconductor device according to one or more embodiments, focusing mainly on the differences from the previous descriptions.

The third and fourth backside wiring lines 70 and 80 may be disposed in a backside interlayer insulating film 290. The third backside wiring line 70 may include first and second surfaces 70_S1 and 70_S2 that are opposite to each other in the third direction Z. The first surface 70_S1 of the third backside wiring line 70 may face the third active pattern AP3.

The third active pattern AP3 may include a third base pattern BP3. The third active pattern AP3 may further include third sheet patterns, which are disposed on the third base pattern BP3.

The fourth active pattern AP4 may include a fourth base pattern BP4. The fourth active pattern AP4 may further include fourth sheet patterns, which are disposed on the fourth base pattern BP4.

A field insulating film 105 may be disposed over the third and fourth backside wiring lines 70 and 80. The field insulating film 105 may be disposed on the sidewalls of the third and fourth base patterns BP3 and BP4.

The second gate electrodes 220 may be disposed on the third and fourth base patterns BP3 and BP4. Some of the second gate electrodes 220 may be divided into two sections by a gate separation structure disposed on the field insulating film 105, and may thereby be disposed over the third and fourth active patterns AP3 and AP4.

The third source/drain patterns 350 may be disposed on the third base pattern BP3. The third source/drain patterns 350 may include third facet intersections 350FC. The fourth source/drain patterns 450 may be disposed on the fourth base pattern BP4. The fourth source/drain patterns 450 may include fourth facet intersections 450FC.

The third frontside source/drain contacts 375 may be disposed on the third source/drain patterns 350. The third frontside source/drain contacts 375 may be connected to the third source/drain patterns 350.

The fourth frontside source/drain contacts 475 may be disposed on the fourth source/drain patterns 450. The fourth frontside source/drain contacts 475 may be connected to the fourth source/drain patterns 450.

A third frontside contact silicide film 365 may be disposed between the third frontside source/drain contact 375 and the third source/drain pattern 350. A fourth frontside contact silicide film 465 may be disposed between the fourth frontside source/drain contact 475 and the fourth source/drain pattern 450.

The first sacrificial epitaxial pattern 170SC of FIG. 12 may not be disposed below the third source/drain pattern 350 connected to the third frontside source/drain contact 375. Similarly, the first sacrificial epitaxial pattern 170SC may not be disposed below the fourth source/drain pattern 450 connected to the fourth frontside source/drain contact 475.

The second air structure 191AG may be disposed in a first frontside interlayer insulating film 190. The second air structure 191AG may be surrounded by the first frontside interlayer insulating film 190.

The second air structure 191AG may be disposed between the third source/drain pattern 350 and the fourth source/drain pattern 450. The third source/drain pattern 350 and the fourth source/drain pattern 450, disposed on either side of the second air structure 191AG, may not be connected to the third backside source/drain contact 370 and the fourth backside source/drain contact 470, respectively.

In the semiconductor device according to one or more embodiments, a height (H14 - H13) of the second air structure 191AG may differ from a height (H22 - H12) of the first air structure 190AG of FIG. 4. For example, the height (H14 - H13) of the second air structure 191AG may be smaller than the height (H22 - H12) of the first air structure 190AG of FIG. 4.

Here, the height (H14 - H13) of the second air structure 191AG may represent a difference between a height H14 of an uppermost part of the second air structure 191AG and a height H13 of a lowermost part of the second air structure 191AG. The height H14 of the uppermost part of the second air structure 191AG and the height H13 of the lowermost part of the second air structure 191AG may be measured from a level of the first surface 70_S1 of the third backside wiring line 70.

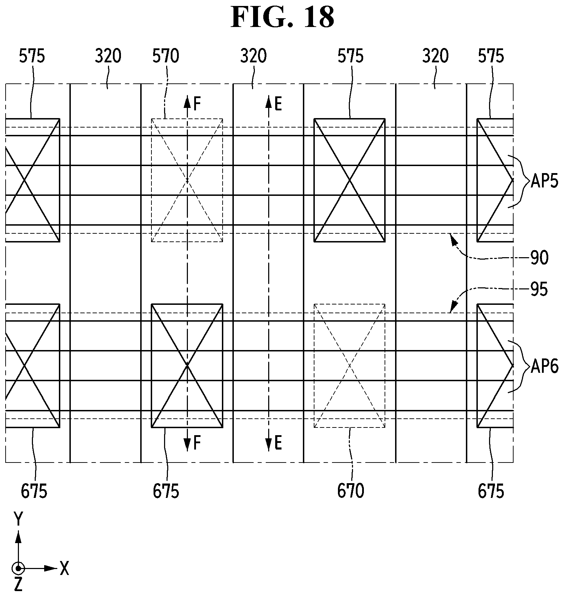

FIGS. 18 through 21 are diagrams for explaining semiconductor devices according to various embodiments.

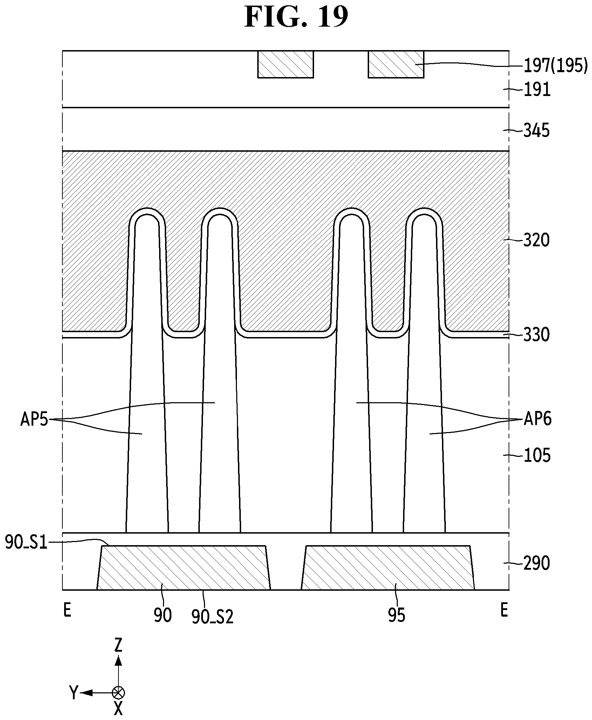

Specifically, FIG. 18 is a layout diagram for explaining a semiconductor device according to one or more embodiments, FIG. 19 is a cross-sectional view taken along line E-E in FIG. 18, and FIGS. 20 and 21 are cross-sectional views taken along line F-F in FIG. 18.

A cross-sectional view taken across each fifth or sixth active pattern AP5 or AP6 along the first direction X may be similar to what is illustrated in FIG. 2, except for the absence of the first sheet patterns NS1 and the inner gate structures I_GS of FIG. 2.

Referring to FIGS. 18 through 21, the semiconductor devices according to one or more embodiments may each include fifth active patterns AP5, sixth active patterns AP6, a plurality of third gate electrodes 320, fifth source/drain patterns 550, sixth source/drain patterns 650, a fifth backside source/drain contact 570, a sixth backside source/drain contact 670, fifth frontside source/drain contacts 575, sixth frontside source/drain contacts 675, a fifth backside wiring line 90, a sixth backside wiring line 95, a third air structure 192AG, and a frontside wiring structure 195.

The fifth and sixth backside wiring lines 90 and 95 may be disposed in a backside interlayer insulating film 290. The fifth and sixth backside wiring lines 90 and 95 may extend in the first direction X. The fifth and sixth backside wiring lines 90 and 95 may be either power lines or signal lines.

The fifth backside wiring line 90 may have first and second surfaces 90_S1 and 90_S2 that are opposite to each other in the third direction Z. The first surface 90_S1 of the fifth backside wiring line 90 may face the fifth active pattern AP5.

The fifth active patterns AP5 and the sixth active patterns AP6 may be disposed on the backside interlayer insulating film 290. The fifth active patterns AP5 and the sixth active patterns AP6 may be disposed on the first surface 90_S1 of the fifth backside wiring line 90 and a first surface of the sixth backside wiring line 95, respectively. The fifth active patterns AP5 and the sixth active patterns AP6 may extend in the first direction X. The first surface 90_S1 of the fifth backside wiring line 90 and the first surface of the sixth backside wiring line 95 may be disposed at a same level in the third direction Z.

Two fifth active patterns AP5 and two sixth active patterns AP6 may be disposed on the backside interlayer insulating film 190, but the present disclosure is not limited thereto. For example, the fifth active patterns AP5 and the sixth active patterns AP6 may be disposed in transistor areas of the same conductivity type. In another example, the fifth active patterns AP5 and the sixth active patterns AP6 may be disposed in transistor areas of different conductivity types.

The fifth active patterns AP5 and the sixth active patterns AP6 may each include an elemental semiconductor material such as Si or Ge. Alternatively, the fifth active patterns AP5 and the sixth active patterns AP6 may include a compound semiconductor. The fifth active patterns AP5 and the sixth active patterns AP6 may be fin-type patterns.

The field insulating film 105 may surround parts of the sidewalls of the fifth active patterns AP5 and parts of the sidewalls of the sixth active patterns AP6.

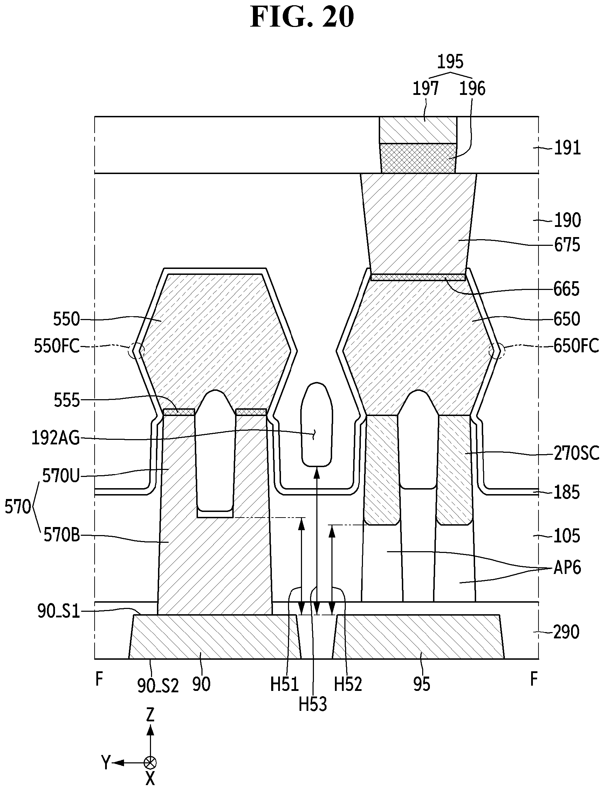

Referring to FIG. 20, no dummy active patterns may be disposed between the fifth active patterns AP5 and the sixth active patterns AP6.

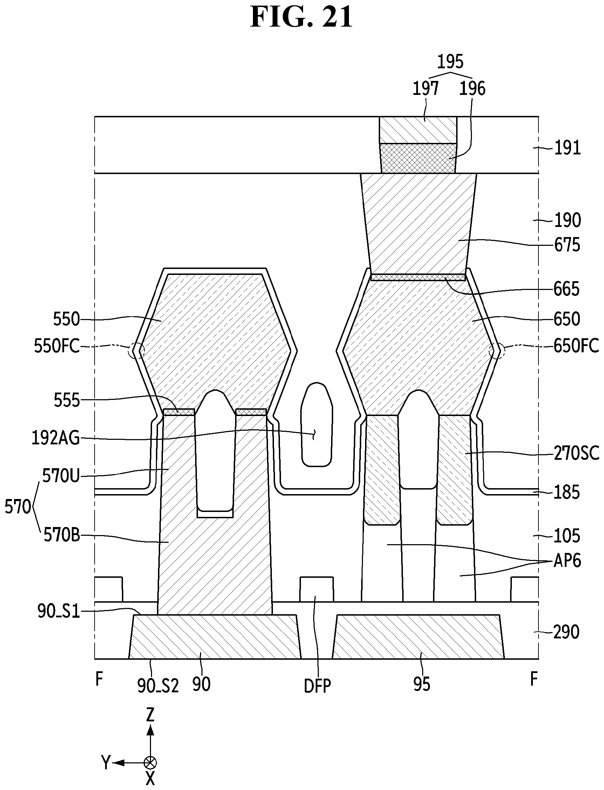

Alternatively, referring to FIG. 21, a dummy active pattern DFP may be disposed between the fifth active pattern AP5 and the sixth active pattern AP6. The dummy active pattern DFP may be formed by removing a part of the fifth active pattern AP5 or a part of the sixth active pattern AP6. The field insulating film 105 may be formed on upper surfaces of the dummy active patterns DFP.

The third gate electrodes 320 may be disposed on the fifth active patterns AP5 and the sixth active patterns AP6. The third gate electrodes 320 may extend in the second direction Y. The third gate electrodes 320 may include at least one of a metal, a conductive metal nitride, a metal silicide, a doped semiconductor material, a conductive metal oxide, and a conductive metal oxynitride.

A second gate insulating film 330 may extend along profiles of the fifth active patterns AP5 and the sixth active patterns AP6 that both protrude beyond the field insulating film 105. The second gate insulating film 330 may extend along the upper surface of the field insulating film 105. The second gate insulating film 330 may be disposed between the fifth active pattern AP5 and the third gate electrode 320, and between the sixth active pattern AP6 and the third gate electrode 320. The second gate insulating film 330 may include silicon oxide, silicon oxynitride, silicon nitride, or a high-k dielectric material that has a higher dielectric constant than silicon oxide.

Second gate capping patterns 345 may be disposed on the third gate electrodes 320. The second gate capping patterns 345 may include an insulating material.

The fifth source/drain patterns 550 may be disposed on the fifth active patterns AP5, respectively. The fifth source/drain patterns 550 may be shared source/drain patterns connected to the fifth active patterns AP5. The fifth source/drain patterns 550 may include fifth facet intersections 550FC, respectively.

Sixth source/drain patterns 650 may be disposed on multiple sixth active patterns AP6. The sixth source/drain patterns 650 may be shared source/drain patterns connected to the sixth active patterns AP6, respectively. The sixth source/drain patterns 650 may include sixth facet intersections 650FC, respectively.

The fifth source/drain patterns 550 and the sixth source/drain patterns 650 may include epitaxial patterns. The fifth source/drain patterns 550 and the sixth source/drain patterns 650 may each include a semiconductor material.

Second sacrificial epitaxial patterns 270SC may be respectively disposed in the sixth active patterns AP6. The second sacrificial epitaxial pattern 270SC may be disposed between the sixth source/drain pattern 650 and the sixth backside wiring line 95. The sixth source/drain patterns 650 may be disposed on the second sacrificial epitaxial patterns 270SC, respectively. The second sacrificial epitaxial patterns 270SC may overlap with the sixth source/drain patterns 650 in the third direction Z, respectively.

The second sacrificial epitaxial patterns 270SC may be disposed below the fifth source/drain pattern 550 not connected to the fifth backside source/drain contact 570. The second sacrificial epitaxial patterns 270SC may include a material with an etch selectivity to the fifth active patterns AP5 and the sixth active patterns AP6.

The fifth backside source/drain contact 570 may be disposed between the fifth source/drain pattern 550 and the fifth backside wiring line 90. The fifth backside source/drain contact 570 connects the fifth source/drain pattern 550 and the fifth backside wiring line 90.

The fifth backside source/drain contact 570 may include a first portion 570B and second portions 570U. The first portion 570B of the fifth backside source/drain contact 570 is directly connected to the second portions 570U of the fifth backside source/drain contact 570.

The fifth backside source/drain contact 570 may include multiple second portions 570U protruding from the first portion 570B. For example, the number of second portions 570U of the fifth backside source/drain contact 570 may be the same as the number of fifth active patterns AP5.

The shape in which the sixth backside source/drain contact 670 and the sixth source/drain patterns 650 are connected may be substantially similar to the shape in which the fifth backside source/drain contact 570 and the fifth source/drain patterns 550 are connected. The description for the fifth backside source/drain contact 570 may be directly applicable to the sixth backside source/drain contact 670.

A fifth frontside contact silicide film 555 may be disposed between the fifth backside source/drain contact 570 and the fifth source/drain pattern 550.

A third air structure 192AG may be disposed in a first frontside interlayer insulating film 190. The third air structure 192AG may be surrounded by the first frontside interlayer insulating film 190.

The third air structure 192AG may be disposed between the fifth source/drain pattern 550 and the sixth source/drain pattern 650. The third air structure 192AG may be disposed between the fifth backside source/drain contact 570 and the second sacrificial epitaxial pattern 270SC.

The third air structure 192AG may be disposed between fifth and sixth backside source/drain contact 570 and 670 that are adjacent to each other in the second direction Y.

A height H51 from a level of the first surface 90_S1 of the fifth backside wiring line 90 to an uppermost part of the first portion 570B of the fifth backside source/drain contact 570 may be smaller than a height H53 from the level of the first surface 90_S1 of the fifth backside wiring line 90 to a lowermost part of the first air structure 190AG. A height H52 from the level of the first surface 90_S1 of the fifth backside wiring line 90 to respective lowermost parts of the second sacrificial epitaxial patterns 270SC may be smaller than the height H53 from the level of the first surface 90_S1 of the fifth backside wiring line 90 to the lowermost part of the first air structure 190AG.

The height H51 from the level of the first surface 90_S1 of the fifth backside wiring line 90 to the uppermost part of the first portion 570B of the fifth backside source/drain contact 570 may be equal to or greater than the height H52 from the level of the first surface 90_S1 of the fifth backside wiring line 90 to the respective lowermost parts of the second sacrificial epitaxial patterns 270SC.

The sixth frontside source/drain contacts 675 may be disposed on the sixth source/drain patterns 650, respectively. The sixth frontside source/drain contacts 675 may be connected to the sixth source/drain patterns 650, respectively. The sixth frontside source/drain contacts 675 may be connected to the frontside wiring line 197.

A sixth frontside contact silicide film 665 may be disposed between the sixth frontside source/drain contact 675 and the sixth source/drain pattern 650.

A shape in which the fifth frontside source/drain contacts 575 are connected to the fifth source/drain patterns 550 may be substantially the same as the shape in which the sixth frontside source/drain contacts 675 are connected to the sixth source/drain patterns 650.

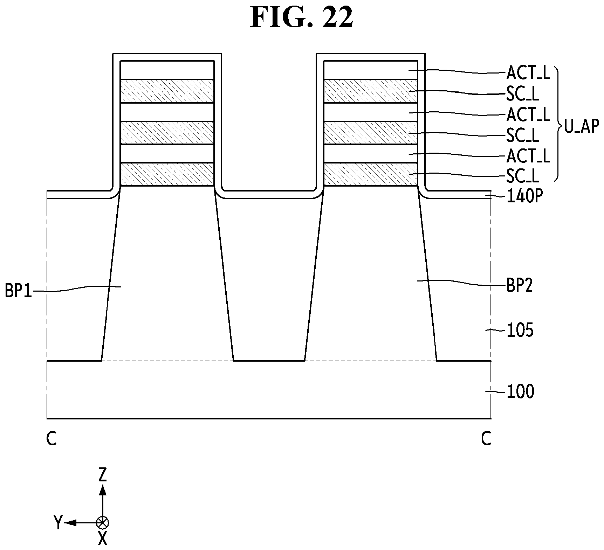

FIGS. 22 through 29 are cross-sectional views for explaining intermediate steps of a method of manufacturing a semiconductor device according to one or more embodiments.

Referring to FIG. 22, a first base pattern BP1 and an upper pattern structure U_AP may be formed on a substrate 100.

A second base pattern BP1 and another upper pattern structure U_AP may be formed on the substrate 100.

The first and second base patterns BP1 and BP2 may extend in the first direction X. The upper pattern structures U_AP may be respectively disposed on the first and second base patterns BP1 and BP2.

The upper pattern structures U_AP may include sacrificial patterns SC_L and active patterns ACT L, which are stacked alternatingly with the sacrificial patterns SC_L. The sacrificial patterns SC_L and the active patterns ACT_L may be alternately stacked on each of the first and second base patterns BP1 and BP2.

The substrate 100 may include bulk silicon or silicon-on-insulator (SOI). Alternatively, the substrate 100 may be a silicon substrate or may include another material, such as silicon-germanium (SiGe), SiGe-on-insulator (SGOI), indium antimonide, lead telluride compounds, indium arsenide, indium phosphide, gallium arsenide, or gallium antimonide, but the present disclosure is not limited thereto.

For example, the sacrificial patterns SC_L may include a SiGe film. The active patterns ACT_L may include a Si film.

The field insulating film 105 may be formed on the substrate 100. The field insulating film 105 may surround least some parts of the sidewalls of the first base pattern BP1 and at least parts of the sidewalls of the second base pattern BP2.

Thereafter, a pre-spacer film 140P may be formed along sidewalls and upper surfaces of the upper pattern structures U_AP and an upper surface of the field insulating film 105. The pre-spacer film 140P may include, for example, at least one of SiN, SiON, SiOCN, SiBN, SiOBN, SiOC, and a combination thereof.

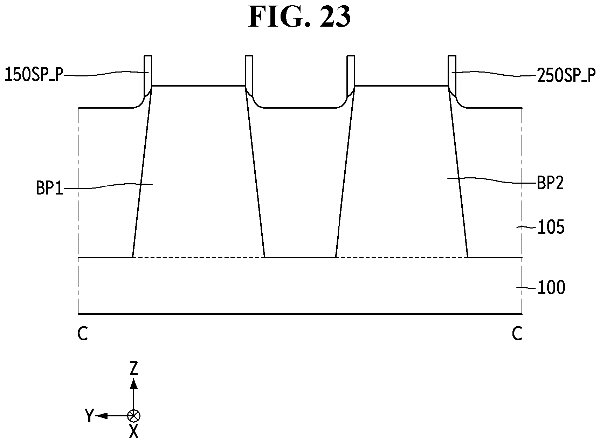

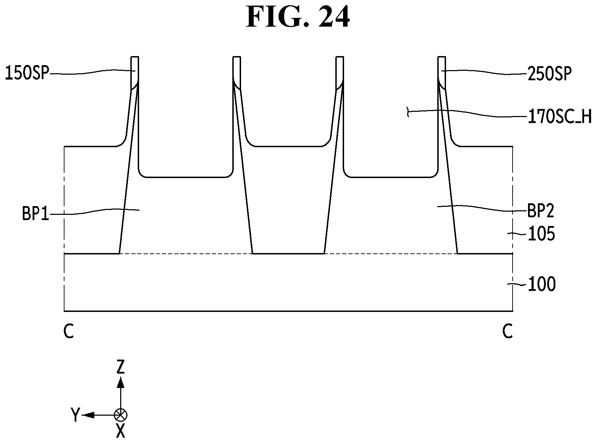

Referring to FIGS. 23 and 24, the upper pattern structures U_AP of the first and second base patterns BP1 and BP2 may be removed using a first etching process.

During the removal of the upper pattern structures U _AP, parts of the pre-spacer film 140P disposed on the upper surfaces of the upper pattern structures U_AP may also be removed. Also, parts of the pre-spacer film 140P on the sidewalls of the upper pattern structures U_AP may also be removed. Consequently, first pre-epitaxial spacers 150SP_P and second pre-epitaxial spacers 250SP_P may be formed on the upper surface of the field insulating film 105.

Thereafter, using a second etching process, parts of the first and second base patterns BP1 and BP2 may be removed. Consequently, sacrificial epitaxial holes 170SC_H may be formed in the first and second base patterns BP1 and BP2.

During the formation of the sacrificial epitaxial holes 170SC_H, at least some parts of the first pre-epitaxial spacers 150SP_P and at least some parts of the second pre-epitaxial spacer 250SP_P may also be removed. As a result, first epitaxial spacers 150SP and second epitaxial spacers 250SP may be formed on the field insulating film 105.

Additionally, during the formation of the sacrificial epitaxial holes 170SC_H, parts of the field insulating film 105 may be removed.

For example, the first and second etching processes may be parts of a single continuous etching process. Alternatively, in another example, there may be an interval between the first and second etching processes. That is, the first and second etching processes may proceed as separate processes.

Contrary to what is illustrated, an etch-stop mask film may be formed on the second base pattern BP2. In this case, the sacrificial epitaxial hole 170SC_H in the second base pattern BP2 may not be formed, and only the sacrificial epitaxial hole 170SC_H in the first base pattern BP1 may be formed.

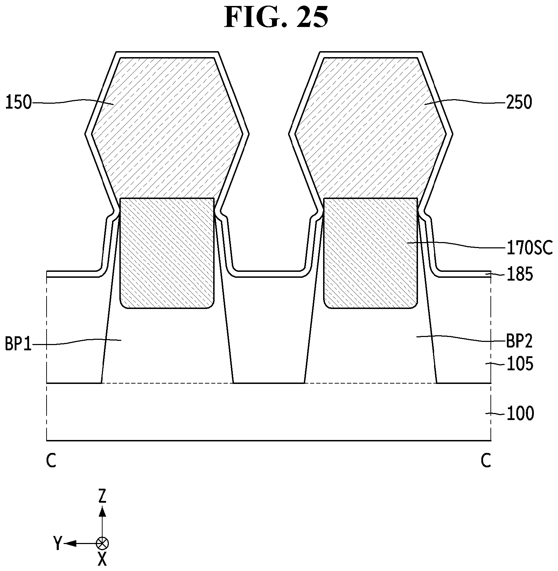

Referring to FIGS. 24 and 25, first sacrificial epitaxial patterns 170SC may be formed in the sacrificial epitaxial holes 170SC_H.

The first sacrificial epitaxial patterns 170SC may be formed in the first and second base patterns BP1 and BP2.

A first source/drain pattern 150 may be formed on the first sacrificial epitaxial pattern 170SC. Similarly, a second source/drain pattern 250 may be formed on the first sacrificial epitaxial pattern 170SC.

During the formation of the first sacrificial epitaxial patterns 170SC, the first epitaxial spacers 150SP and/or the second epitaxial spacers 250SP may be removed by a pre-epitaxial process treatment.

During the formation of the first source/drain pattern 150, the first epitaxial spacers 150SP may be removed by the pre-epitaxial process treatment. During the formation of the second source/drain pattern 250, the second epitaxial spacers 250SP may be removed by the pre-epitaxial process treatment.

Contrary to what is illustrated, the first epitaxial spacers 150SP may remain after the formation of the first source/drain pattern 150. The second epitaxial spacers 250SP may remain after the formation of the second source/drain pattern 250.

A source/drain etch-stop film 185 may be formed along the upper surface of the field insulating film 105, and profiles of the first and second source/drain patterns 150 and 250.

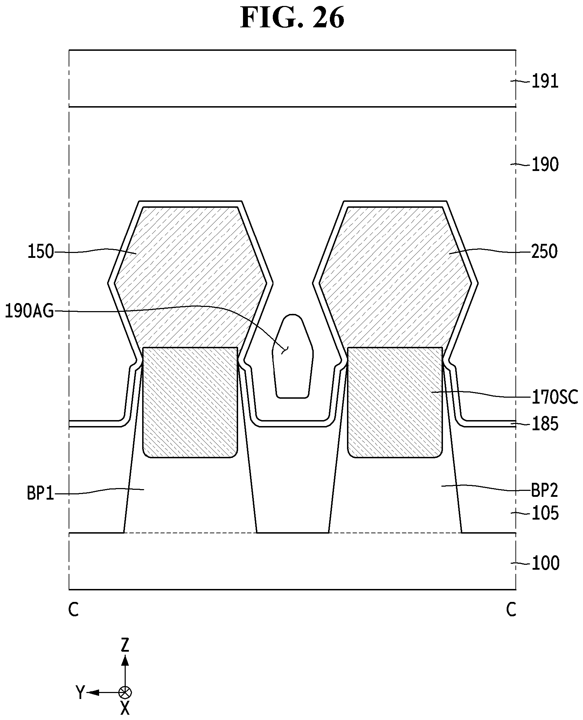

Referring to FIG. 26, a first frontside interlayer insulating film 190 may be formed on the source/drain etch stop film 185.

During the formation of the first frontside interlayer insulating film 190, a first air structure 190AG may be formed between the first and second source/drain patterns 150 and 250. The first air structure 190AG may also be formed between the first and second base patterns BP1 and BP2. The first air structure 190AG may be formed between the first sacrificial epitaxial patterns 170SC that are adjacent to each other in the second direction Y.

Thereafter, a second frontside interlayer insulating film 191 may be formed on the first frontside interlayer insulating film 190.

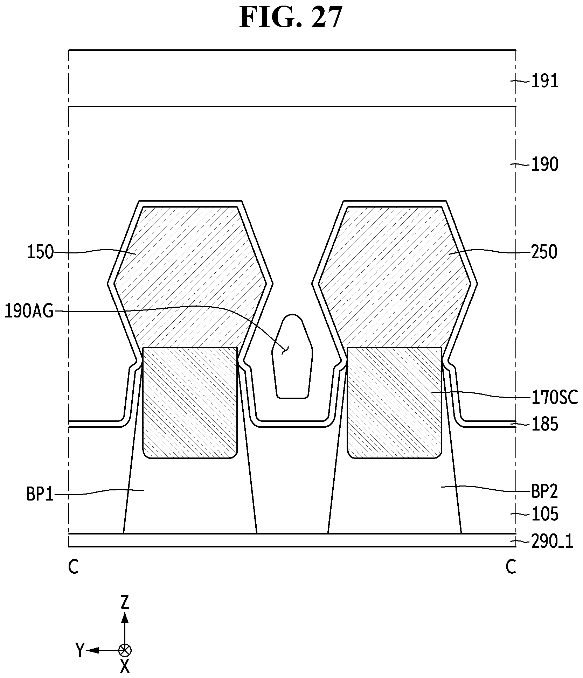

Referring to FIGS. 26 and 27, the substrate 100 may be removed.

Due to the removal of the substrate 100, the first and second base patterns BP1 and BP2 may be exposed, and the field insulating film 105 may also be exposed.

Thereafter, a first backside interlayer insulating film 290_1 may be formed on the first and second base patterns BP1 and BP2.

Contrary to what is illustrated, the first backside interlayer insulating film 290_1 may not be formed.

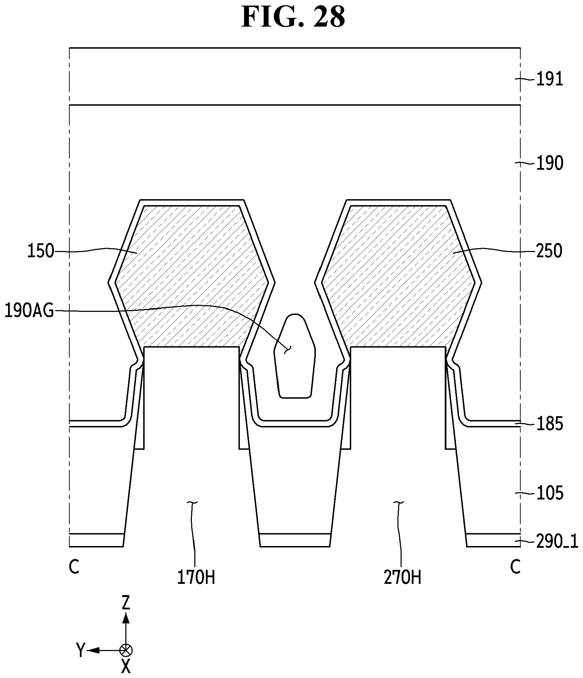

Referring to FIGS. 27 and 28, a first backside source/drain contact hole 170H may be formed by removing the first base pattern BP1 and the first sacrificial epitaxial pattern 170SC on the first base pattern BP1.

A second backside source/drain contact hole 270H may be formed by removing the second base pattern BP2 and the first sacrificial epitaxial pattern 170SC on the second base pattern BP2.

The first backside source/drain contact hole 170H may expose the first source/drain pattern 150. The second backside source/drain contact hole 270H may expose the second source/drain pattern 250.

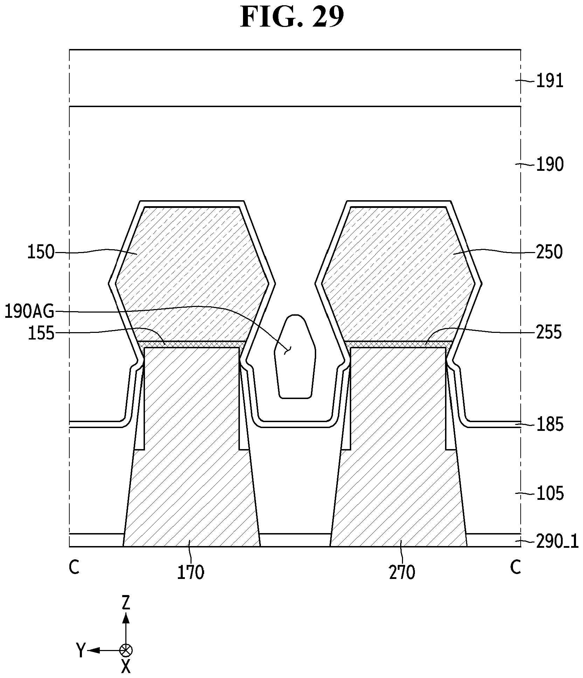

Referring to FIGS. 28 and 29, a first backside source/drain contact 170 may be formed in the first backside source/drain contact hole 170H.

The first backside source/drain contact 170 may be connected to the first source/drain pattern 150. During the formation of the first backside source/drain contact 170, a first backside contact silicide film 155 may be formed.

A second backside source/drain contact 270 may be formed in the second backside source/drain contact hole 270H. The second backside source/drain contact 270 may be connected to the second source/drain pattern 250. During the formation of the second backside source/drain contact 270, a second backside contact silicide film 155 may be formed.

Thereafter, referring to FIG. 4, a second backside interlayer insulating film may be formed on the first and second backside source/drain contacts 170 and 270. The first backside interlayer insulating film 290_1 and the second backside interlayer insulating film may become a backside interlayer insulating film 290. First and second backside wiring lines 50 and 60 may be formed within the second backside interlayer insulating film.

Contrary to what is illustrated in FIG. 27, the backside interlayer insulating film 290 may be formed on the first and second base patterns BP1 and BP2. Additionally, contrary to what is illustrated in FIG. 28, trenches in which the first and second backside wiring lines 50 and 60 are to be formed may be formed in the backside interlayer insulating film 290.

In this case, the first backside wiring line 50 and the first backside source/drain contact 170 may be formed together, and the second backside wiring line 60 and the second backside source/drain contact 270 may be formed together.

Although example embodiments have been described with reference to the accompanying drawings, the present disclosure is not limited to the above embodiments, but may be implemented in various different forms. A person skilled in the art may appreciate that the present disclosure may be practiced in other concrete forms without changing the technical spirit or essential characteristics. Therefore, it should be appreciated that the embodiments as described above is not restrictive but illustrative in all respects.

## Claims

1. A semiconductor device comprising:
a backside wiring line having first and second surfaces that are opposite to each other in a third direction;
a first fin-type pattern on the first surface of the backside wiring line and extending in a first direction;
a second fin-type pattern on the first surface of the backside wiring line, extending in the first direction and spaced apart from the first fin-type pattern in a second direction;
a first source/drain pattern on the first fin-type pattern;
a second source/drain pattern on the second fin-type pattern;
a first backside source/drain contact connecting the backside wiring line and the first source/drain pattern; and
an air structure between the first and second source/drain patterns, the air structure overlapping the first backside source/drain contact in the second direction,
wherein the first backside source/drain contact comprises a first portion and a second portion,
wherein the first portion of the first backside source/drain contact is disposed between the backside wiring line and the second portion of the first backside source/drain contact,
wherein in the first portion of the first backside source/drain contact, a width, in the second direction, of the first backside source/drain contact decreases away from the first surface of the backside wiring line,
wherein the second portion of the first backside source/drain contact is connected to the first source/drain pattern,
wherein a height from the first surface of the backside wiring line to an uppermost part of the first portion of the first backside source/drain contact is smaller than a height from a level of the first surface of the backside wiring line to a lowermost part of the air structure.

2. The semiconductor device of claim 1, further comprising:
a sacrificial epitaxial pattern between the second source/drain pattern and the backside wiring line,
wherein the sacrificial epitaxial pattern is in the second fin-type pattern.

3. The semiconductor device of claim 2, further comprising:
a frontside source/drain contact connected to the second source/drain pattern; and
a frontside wiring line connected to the frontside source/drain contact.

4. The semiconductor device of claim 2, wherein a height from the level of the first surface of the backside wiring line to a lowermost part of the sacrificial epitaxial pattern is smaller than a height from the level of the first surface of the backside wiring line to the lowermost part of the air structure.

5. The semiconductor device of claim 1, further comprising:
a second backside source/drain contact connecting the backside wiring line and the second source/drain pattern,
wherein at least a portion of the air structure is between the first and second backside source/drain contacts.

6. The semiconductor device of claim 5, wherein a height from the first surface of the backside wiring line to an uppermost part of the first backside source/drain contact differs from a height from the level of the first surface of the backside wiring line to an uppermost part of the second backside source/drain contact.

7. The semiconductor device of claim 1, wherein the first source/drain pattern comprises facet intersections,
wherein at the facet intersections of the first source/drain pattern, a width, in the second direction, of the first source/drain pattern is at its maximum, and
wherein a height from the level of the first surface of the backside wiring line to the facet intersections of the first source/drain pattern is greater than the height from the level of the first surface of the backside wiring line to an uppermost part of the air structure.

8. The semiconductor device of claim 1, wherein the air structure comprises a first sub-air structure and a second sub-air structure, which are spaced apart from each other in the first direction.

9. The semiconductor device of claim 1, further comprising:
a plurality of sheet patterns disposed on the first fin-type pattern and spaced apart from the first fin-type pattern in the third direction,
wherein the first source/drain pattern contacts the plurality of sheet patterns.

10. A semiconductor device comprising:
a backside wiring line having first and second surfaces that are opposite to each other in a third direction;
a first fin-type pattern on the first surface of the backside wiring line and extending in a first direction;
a second fin-type pattern on the first surface of the backside wiring line, extending in the first direction and spaced apart from the first fin-type pattern in a second direction;
a third first fin-type pattern on the first surface of the backside wiring line and extending in the first direction;
a fourth fin-type pattern on the first surface of the backside wiring line, extending in the first direction and spaced apart from the third fin-type pattern in the second direction;
a first source/drain pattern on the first fin-type pattern;
a second source/drain pattern on the second fin-type pattern;
a third source/drain pattern on the third fin-type pattern;
a fourth source/drain pattern on the fourth fin-type pattern;
a backside source/drain contact connecting the backside wiring line and the first source/drain pattern;
a first air structure between the first and second source/drain patterns; and
a second air structure between the third and fourth source/drain patterns,
wherein a height, in the third direction, of the first air structure differs from a height, in the third direction, of the second air structure.

11. The semiconductor device of claim 10, wherein the height of the first air structure is greater than the height of the second air structure.

12. The semiconductor device of claim 10, wherein the backside source/drain contact comprises a first portion and a second portion,
wherein the first portion of the backside source/drain contact is disposed between the backside wiring line and the second portion of the backside source/drain contact,
wherein in the first portion of the backside source/drain contact, a width, in the second direction, of the backside source/drain contact decreases away from the first surface of the backside wiring line,
wherein the second portion of the backside source/drain contact is connected to the first source/drain pattern, and
wherein a height from the first surface of the backside wiring line to an uppermost part of the first portion of the backside source/drain contact is smaller than a height from a level of the first surface of the backside wiring line to a lowermost part of the first air structure.

13. The semiconductor device of claim 10, further comprising:
a frontside source/drain contact connected to at least one of the third and fourth source/drain patterns; and
a frontside wiring line connected to the frontside source/drain contact,
wherein the at least one of the third and fourth source/drain patterns is not connected to the backside wiring line.

14. A semiconductor device comprising:
a first backside wiring line having first and second surfaces that are opposite to each other in a third direction;
a second backside wiring line having first and second surfaces that are opposite to each other in the third direction;
a first fin-type pattern on the first surface of the first backside wiring line and extending in a first direction;
a plurality of first sheet patterns on the first fin-type pattern;
a second fin-type pattern on the first surface of the second backside wiring line, extending in the first direction and spaced apart from the first fin-type pattern in a second direction;
a plurality of second sheet patterns on the second fin-type pattern;
a first source/drain pattern on the first fin-type pattern and connected to the plurality of first sheet patterns;
a second source/drain pattern on the second fin-type pattern and connected to the plurality of second sheet patterns;
a first backside source/drain contact connecting the first backside wiring line and the first source/drain pattern;
a second backside source/drain contact connecting the second backside wiring line and the second source/drain pattern; and
an air structure between the first and second source/drain patterns, the air structure overlapping the first and second backside source/drain contacts in the third direction.

15. The semiconductor device of claim 14, wherein the first and second source/drain patterns include impurities of the same conductivity type.
